# FASCICULE DE BREVET EUROPEEN

(11) **EP 4 519 704 B1**
(45) Date de publication et mention de la délivrance du brevet: **04.11.2026**
(21) Numéro de dépôt: 23723903.3
(22) Date de dépôt: 02.05.2023
(51) Int. Cl.: G01R 31/3842, G01R 31/367, G01R 31/36

(54) **PROCÉDÉ D'ESTIMATION DE L'ÉTAT DE CHARGE D'UN ÉLÉMENT ÉLECTROCHIMIQUE ET DISPOSITIFS ASSOCIÉS**
VERFAHREN ZUR SCHÄTZUNG DES LADEZUSTANDES EINES ELEKTROCHEMISCHEN ELEMENTS UND ZUGEHÖRIGE VORRICHTUNGEN
METHOD FOR ESTIMATING THE STATE OF CHARGE OF AN ELECTROCHEMICAL ELEMENT AND ASSOCIATED DEVICES

(30) Priorité: 03.05.2022 FR 2204190
(43) Date de publication de la demande: 12.03.2025
(73) Titulaire: SAFT, 92300 Levallois-Perret (FR)
(72) Inventeur: MONIER-REYES, Daniel, 33480 AVENSAN (FR); DUFOUR, Nicolas, 78470 SAINT-REMY LES CHEVREUSE (FR); BARRAILH, Gérard, 64360 MONEIN (FR)
(74) Mandataire: Lavoix
(86) Numéro de dépôt international: PCT/EP2023/061481
(87) Numéro de publication internationale: WO 2023/213781

(56) Documents cités:
- US-A1- 2018 017 628
- KUCHLY JEAN ET AL: "Li-ion battery SOC estimation method using a Neural Network trained with data generated by a P2D model", IFAC-PAPERSONLINE, vol. 54, no. 10, 31 August 2021 (2021-08-31), DE, pages 336 - 343, XP093000664, ISSN: 2405-8963, DOI: 10.1016/j.ifacol.2021.10.185

## Description

La présente invention concerne un procédé d'estimation de l'état de charge d'au moins un élément électrochimique d'une batterie. La présente invention se rapporte aussi à un calculateur, un système de gestion et une batterie associés.

Typiquement une batterie comprend un ou plusieurs accumulateurs de courant appelés aussi générateurs électrochimiques, cellules ou éléments. Un accumulateur est un dispositif de production d'électricité dans lequel de l'énergie chimique est convertie en énergie électrique. L'énergie chimique provient des composés électrochimiquement actifs déposés sur au moins une face d'électrodes disposées dans l'accumulateur. L'énergie électrique est produite par des réactions électrochimiques au cours d'une décharge de l'accumulateur. Les électrodes, disposées dans un conteneur, sont connectées électriquement à des bornes de sortie de courant qui assurent une continuité électrique entre les électrodes et un consommateur électrique auquel l'accumulateur est associé.

Afin d'augmenter la puissance électrique délivrée, on peut associer plusieurs accumulateurs étanches entre eux pour former une batterie. Ainsi, une batterie peut être divisée en modules, chaque module étant composé d'un ou plusieurs accumulateurs reliés entre eux en série et/ou en parallèle. Ainsi, une batterie peut par exemple comporter une ou plusieurs branches parallèles d'accumulateurs reliés en série et/ou une ou plusieurs branches parallèles de modules reliés en série.

Un circuit de charge est généralement prévu auquel la batterie peut être branchée pour recharger les accumulateurs.

Par ailleurs, un système de gestion électronique comprenant des capteurs de mesures et un circuit électronique de contrôle, plus ou moins évolué selon les applications, peut être associé à la batterie. Un tel système permet notamment d'organiser et de contrôler la charge et la décharge de la batterie, pour équilibrer la charge et la décharge des différents accumulateurs de la batterie les uns par rapport aux autres.

L'état de charge est une information utile au système électronique de gestion de la batterie pour optimiser son utilisation et sa durée de vie. L'état de charge est souvent désigné par l'abréviation SOC qui renvoie à la dénomination anglaise de « State of Charge ».

Pour obtenir l'état de charge SOC, il est connu d'utiliser deux techniques de calcul utilisant des mesures continues de l'évolution de la tension, du courant et de la température.

La première technique peut être qualifiée de « coulométrique » dans la mesure où il est utilisé le fait que l'état de charge SOC dépend de la charge (comptage des Ampères-heures) et de la capacité Q de la batterie.

En effet, il vient les formules suivantes : $SOC = {SOC}_{0} + \frac{{\int }_{0}^{t} I \times dt}{Q}$

Où *: SOC*₀ est la valeur initiale de l'état de charge SOC à l'instant t=0.

Toutefois, cette première technique est très sensible à l'erreur de mesure en courant ainsi qu'à l'estimation de la capacité. De ce fait, l'utilisation seule de cette technique conduit à de l'accumulation de l'erreur de mesure du courant, ce qui induit une estimation erronée de l'état de charge.

La deuxième technique est basée sur les mesures de la tension en circuit ouvert OCV et utilise une table de correspondance préétablie pour obtenir l'état de charge SOC en fonction de la tension en circuit ouvert. La tension en circuit ouvert est souvent désignée par l'abréviation OCV qui renvoie à la dénomination anglaise de « Open Circuit Voltage ».

Comme la fonction qui lie la tension en circuit ouvert OCV à l'état de charge SOC est une fonction de la tension à laquelle est soustraite le produit de la résistance par le courant, la deuxième technique est une technique sensible à l'estimation de la résistance. Aussi, il convient d'utiliser la deuxième technique dans des conditions permettant de minimiser l'erreur sur la résistance, à savoir des conditions de repos ou de courant faible.

Il est connu d'utiliser les deux techniques précitées en utilisant la première technique comme technique habituelle et en recalibrant de manière régulière l'état de charge SOC à l'aide de la deuxième technique.

Toutefois, dans certains éléments électrochimiques, du fait que la variation de la tension en circuit ouvert en fonction de l'état de charge SOC présente un plateau, la correspondance entre la tension en circuit ouvert OCV et l'état de charge SOC peut être fausse.

Ainsi, il est connu d'effectuer un recalage en effectuant une recharge avec un état de charge SOC supérieur à l'état de charge SOC maximal correspondant à la fin du plateau.

Une telle technique impose alors généralement l'interruption de la mission de l'élément électrochimique pour effectuer la recharge. C'est notamment le cas pour des missions de régulation de fréquence qui impliquent des cycles sur le plateau. De telles interruptions peuvent être incompatibles avec la mission.

Le document US 2018/017628 A1 divulgue un calcul d'un état de charge d'une batterie. Une première valeur est basée sur l'intégration d'un courant mesuré et une deuxième valeur est basée sur une mesure d'une tension à circuit ouvert. Une différence entre ces deux valeurs est donnée en entrée à un algorithme itératif afin de corriger les paramètre du modèle de calcul basé sur l'intégration d'un courant mesuré.

Le document "Li-ion battery SOC estimation method using a Neural Network trained with data generated by a P2D model", Kuchly Jean et al, IFAC-PapersOnLine, vol. 54, no. 10, 31 août 2021, divulgue l'estimation d'un état de charge d'une batterie par deux méthodes, une première méthode basée sur l'intégration d'un courant, et une deuxième méthode utilisant un réseau de neurones appris, et une comparaison entre ces deux méthodes.

Il existe donc un besoin pour un procédé d'estimation de l'état de charge SOC d'un élément électrochimique qui soit plus précis et réalisable en fonctionnement normal de l'élément électrochimique.

A cet effet, la description décrit un procédé d'estimation de l'état de charge d'au moins un élément électrochimique d'une batterie, le procédé étant mis en oeuvre par un calculateur, le calculateur mémorisant un modèle d'estimation de l'état de charge estimant à partir d'une valeur de tension, d'une valeur de courant, d'une valeur de température et d'une valeur de capacité de l'au moins un élément électrochimique la valeur de l'état de charge de l'au moins un élément électrochimique, le modèle d'estimation de l'état de charge étant un réseau de neurones appris,
le procédé comprenant, pour plusieurs instants, les étapes de :
- obtention de valeurs de la tension, du courant, de la température et de la capacité de l'au moins un élément électrochimique,
- calcul de la valeur de l'état de charge de l'au moins un élément électrochimique selon une première technique et une deuxième technique,
   la première technique comportant les opérations suivantes :
      - obtention d'une valeur estimée de l'état de charge obtenue à un instant antérieur,
      - calcul de la valeur de la quantité de charge accumulée depuis l'instant antérieur par utilisation des valeurs du courant obtenues,
      - déduction d'une première valeur calculée de l'état de charge par calcul de la somme de la valeur estimée de l'état de charge obtenue à l'instant antérieur et du ratio de la valeur de la quantité de charge accumulée depuis l'instant antérieur et de la valeur de la capacité de l'au moins un élément électrochimique,
   la deuxième technique comportant les opérations suivantes :
      - application du modèle d'estimation de l'état de charge sur les valeurs obtenues du courant, de la température et de la capacité de l'au moins un élément électrochimique au même instant d'obtention et sur une valeur de tension dépendant de la valeur obtenue de tension de l'au moins un élément électrochimique au même instant d'obtention, pour obtenir une deuxième valeur calculée de l'état de charge,
- comparaison entre la différence en valeur absolue entre la deuxième valeur calculée et la première valeur calculée et la valeur absolue d'un seuil, et
- lorsque la différence en valeur absolue entre la deuxième valeur calculée et la première valeur calculée est inférieure ou égale au seuil, détermination de la valeur estimée de l'état de charge, comme étant la deuxième valeur calculée de l'état de charge,
   ou
- lorsque la différence en valeur absolue entre la deuxième valeur calculée et la première valeur calculée est strictement supérieure au seuil, détermination de la valeur estimée de l'état de charge, comme étant la somme de la première valeur calculée de l'état de charge et d'un facteur de correction proportionnel au seuil.

Selon des modes de réalisation particuliers, le procédé d'estimation présente une ou plusieurs des caractéristiques suivantes, prise(s) isolément ou selon toutes les combinaisons techniquement possibles :
- le facteur de correction est égal au produit d'un coefficient, d'une valeur de direction et du seuil, la valeur de direction étant égale au rapport entre la différence de la deuxième valeur calculée et la première valeur calculée et la valeur absolue de la différence de la deuxième valeur calculée et la première valeur calculée, le coefficient étant avantageusement comprise entre 1 et 2 ;
- le seuil dépend du biais de courant maximal, le biais de courant maximal prenant en compte au moins une contribution choisie dans la liste constituée d'une première contribution provenant d'un capteur de courant fournissant les valeurs de courant, d'une deuxième contribution provenant de l'autodécharge de l'au moins un élément électrochimique et d'une troisième contribution provenant des erreurs sur l'estimation de la capacité de l'au moins un élément électrochimique ;
- le procédé comporte, en outre, une étape de détermination du seuil, le seuil étant égal au rapport entre la valeur de quantité de charge susceptible d'être accumulée depuis l'instant antérieur du fait du biais de courant maximal et la valeur de la capacité de l'au moins un élément électrochimique ;
- la valeur de tension dépendant de la valeur obtenue de tension de l'au moins un élément électrochimique au même instant d'obtention est la valeur obtenue de tension de l'au moins un élément électrochimique au même instant d'obtention ;
- le procédé comporte, en outre, une étape d'estimation de la valeur de la tension en régime établi à l'instant d'obtention, la valeur de tension dépendant de la valeur obtenue de tension de l'au moins un élément électrochimique au même instant d'obtention étant la valeur estimée de tension en régime établi ;
- l'étape d'estimation est mise en oeuvre par application d'un modèle d'estimation de la tension en régime établi sur la valeur de tension de l'au moins un élément électrochimique à l'instant d'obtention, la valeur de courant de l'au moins un élément électrochimique à l'instant d'obtention et le temps écoulé depuis l'instant antérieur ;
- le réseau de neurones est un perceptron multicouche ;
- le réseau de neurones comporte un nombre de neurones inférieur ou égal à 100 ;
- la valeur estimée initiale de l'état de charge est choisie parmi des valeurs prédéfinies et la deuxième valeur calculée ;
- l'au moins un élément électrochimique présentant une caractéristique état de charge - tension en circuit ouvert avec une portion plane, une portion plane étant une portion dans laquelle la variation de tension en circuit ouvert est inférieure à 30 mV pour une variation d'au moins 10% de l'état de charge ;
- l'au moins un élément électrochimique comprend un matériau actif cathodique choisi dans les groupes suivants ou leurs mélanges :
   i) un composé de formule LiₓFe_{1-y}M_{y}PO₄ où M est choisi dans le groupe consistant en B, Mg, Al, Si, Ca, Ti, V, Cr, Mn, Co, Ni, Cu, Zn, Y, Zr, Nb et Mo; et 0,8≤x≤1,2 ; 0≤y≤0,6,
   ii) un composé de formule LiₓMn_{1-y-z}M'_{y}M"_{z}PO₄, où M' et M" sont différents l'un de l'autre et sont choisis dans le groupe consistant en B, Mg, AI, Si, Ca, Ti, V, Cr, Fe, Co, Ni, Cu, Zn, Y, Zr, Nb et Mo, avec 0,8≤x≤1,2 ; 0≤y≤0,6 ; 0,0≤z≤0,2,
   iii) un composé de formule LiₓMn_{2-y-}zNi_{y}M_{z}O_{4-d-c}F_{c} où M représente un ou plusieurs éléments choisis dans le groupe consistant en B, Mg, AI, Si, Ca, Ti, V, Cr, Fe, Co, Cu, Zn, Y, Zr, Nb, Ru, W et Mo;. et 1≤x≤1,4 ; 0<y≤0,6 ; 0≤z≤0,2 ; 0≤d≤1 ; 0≤c≤1,
   iv) un composé de formule LiₓMn_{2-y-z}M'_{y}M"_{z}O₄, où M' et M" sont choisis dans le groupe consistant en B, Mg, AI, Si, Ca, Ti, V, Cr, Fe, Co, Ni, Cu, Zn, Y, Zr, Nb et Mo ;. M' et M" étant différents l'un de l'autre, et 1≤x≤1,4 ; 0≤y≤0,6 ; 0≤z≤0,2, et
   v) un composé de formule LiVPO₄F.

La description propose également un calculateur propre à estimer l'état de charge d'au moins un élément électrochimique d'une batterie,
le calculateur mémorisant un modèle d'estimation de l'état de charge estimant à partir d'une valeur de tension, d'une valeur de courant, d'une valeur de température et d'une valeur de capacité de l'au moins un élément électrochimique la valeur de l'état de charge de l'au moins un élément électrochimique, le modèle d'estimation de l'état de charge étant un réseau de neurones appris,
le calculateur étant, pour plusieurs instants, propre à:
   - obtenir des valeurs de la tension, du courant, de la température et de la capacité de l'au moins un élément électrochimique,
   - calculer la valeur de l'état de charge de l'au moins un élément électrochimique selon une première technique et une deuxième technique,
      la première technique comportant les opérations suivantes :
         - obtention d'une valeur estimée de l'état de charge obtenue à un instant antérieur,
         - calcul de la valeur de la quantité de charge accumulée depuis l'instant antérieur par utilisation des valeurs du courant obtenues,
         - déduction d'une première valeur calculée de l'état de charge par calcul de la somme de la valeur estimée de l'état de charge obtenue à l'instant antérieur et du ratio de la valeur de la quantité de charge accumulée depuis l'instant antérieur et de la valeur de la capacité de l'au moins un élément électrochimique,
      la deuxième technique comportant les opérations suivantes :
         - application du modèle d'estimation de l'état de charge sur les valeurs obtenues du courant, de la température et de la capacité de l'au moins un élément électrochimique au même instant d'obtention et sur une valeur de tension dépendant de la valeur obtenue de tension de l'au moins un élément électrochimique au même instant d'obtention, pour obtenir une deuxième valeur calculée de l'état de charge, et
   - comparer la différence en valeur absolue entre la deuxième valeur calculée et la première valeur calculée et un seuil, et
   - lorsque la différence en valeur absolue entre la deuxième valeur calculée et la première valeur calculée est inférieure ou égale au seuil, déterminer la valeur estimée de l'état de charge, comme étant la deuxième valeur calculée de l'état de charge,
      ou
   - lorsque la différence en valeur absolue entre la deuxième valeur calculée et la première valeur calculée est strictement supérieure au seuil, déterminer la valeur estimée de l'état de charge, comme étant la somme de la première valeur calculée de l'état de charge et d'un facteur de correction proportionnel au seuil.

La description décrit aussi un système de gestion d'au moins un élément électrochimique d'une batterie, l'au moins un élément électrochimique présentant des bornes, le système de gestion comprenant :
- un capteur de tension propre à mesurer la tension aux bornes dudit au moins un élément électrochimique,
- un capteur du courant propre à mesurer le courant délivré par ledit au moins un élément électrochimique,
- un capteur de température propre à mesurer la température dudit au moins un élément électrochimique, et
- un calculateur tel que décrit précédemment. La description propose également une batterie comprenant :
   - au moins un élément électrochimique, et
   - un système de gestion tel que décrit précédemment.

Dans la présente description, l'expression « propre à » signifie indifféremment « adapté pour », « adapté à » ou « configuré pour ».

Des caractéristiques et avantages de l'invention apparaîtront à la lecture de la description qui va suivre, donnée uniquement à titre d'exemple non limitatif, et faite en référence aux dessins annexés, sur lesquels :
- la figure 1 est une représentation schématique d'un exemple de batterie comportant un élément électrochimique,
- la figure 2 est un graphe illustrant un exemple de caractéristique état de charge - tension en circuit ouvert de l'élément électrochimique de la figure 1,
- la figure 3 est une représentation en schéma-bloc d'un exemple de mise en oeuvre de procédé d'estimation de l'état de charge de l'élément électrochimique,
- les figures 4 à 7 sont des courbes expérimentales impliquées dans la mise en oeuvre de certaines étapes du procédé d'estimation décrit à la figure 3 ou dans un procédé de l'état de la technique,
- la figure 8 est une représentation en schéma-bloc d'un autre exemple de mise en oeuvre de procédé d'estimation de l'état de charge de l'élément électrochimique, et
- la figure 9 est un graphe présentant la variation temporelle de tension dans un élément électrochimique.

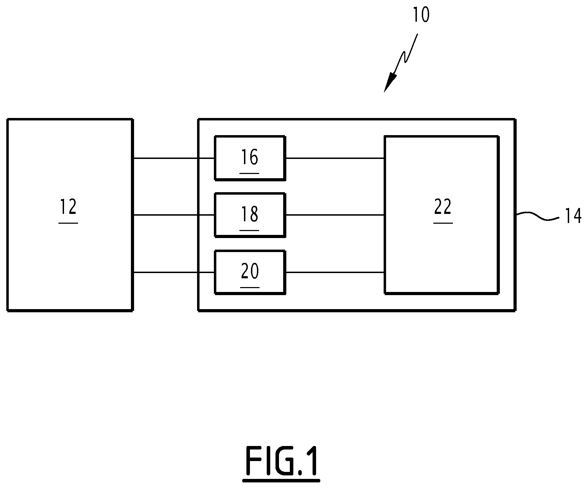

Une batterie 10 est représentée sur la figure 1.

De manière connue en soi, une batterie est généralement un agencement d'une pluralité d'éléments électrochimiques mais dans un souci de simplification du propos, il est décrit un cas à un seul élément électrochimique dans ce qui suit, sachant que la transposition à d'autres agencements est immédiate.

La batterie 10 comporte un élément électrochimique 12 et un système de gestion 14 de l'élément électrochimique 12.

Comme expliqué précédemment, un élément électrochimique 12 est un dispositif de production d'électricité dans lequel de l'énergie chimique est convertie en énergie électrique.

L'élément électrochimique 12 délivre donc un courant et une tension entre deux bornes.

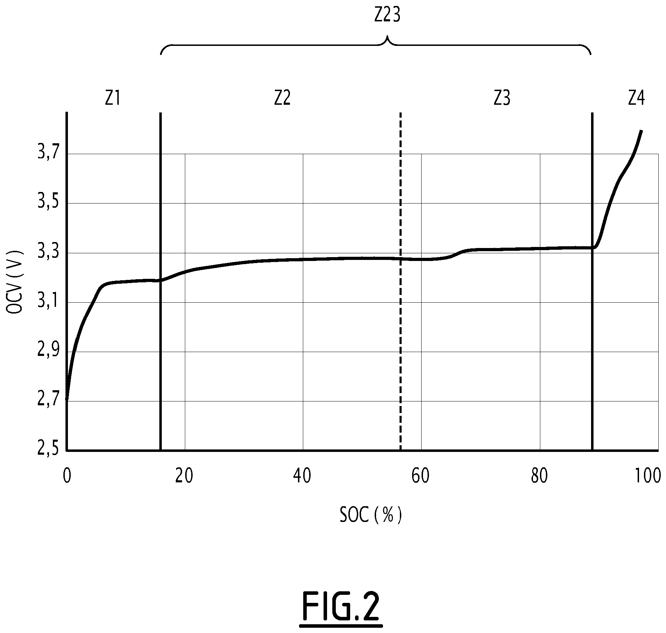

L'élément électrochimique 12 présente une caractéristique état de charge SOC - tension en circuit ouvert OCV telle que visible sur la figure 2. Cette caractéristique est notée caractéristique SOC/OCV dans la suite.

Dans la figure 2, l'état de charge SOC est exprimé en pourcentage d'un état de charge maximale.

La caractéristique SOC/OCV présente quatre zones, une première zone Z1, une deuxième zone Z2, une troisième zone Z3 et une quatrième zone Z4.

La première zone Z1 correspond au début de la charge et la quatrième zone Z4 à la fin de la charge.

Pour les deux zones intermédiaires, dans la mesure où les deuxième zone Z2 et troisième zone Z3 correspondent à une portion plane, il sera utilisé la dénomination portion plane (Z23) dans la suite.

La portion plane Z23 est une portion dans laquelle la variation de tension en circuit ouvert OCV est inférieure à 30 mV pour une variation d'au moins 10% de l'état de charge SOC.

Un tel type de caractéristique SOC/OCV se retrouve notamment lorsque l'élément électrochimique 12 est un élément électrochimique comprenant un matériau actif cathodique choisi dans les groupes suivants ou leurs mélanges :
i) un composé de formule LiₓFe_{1-y}M_{y}PO₄ où M est choisi dans le groupe consistant en B, Mg, AI, Si, Ca, Ti, V, Cr, Mn, Co, Ni, Cu, Zn, Y, Zr, Nb et Mo; et 0,8≤x≤1,2 ; 0≤y≤0,6,
ii) un composé de formule LiₓMn_{1-y-z}M'_{y}M"_{z}PO₄, où M' et M" sont différents l'un de l'autre et sont choisis dans le groupe consistant en B, Mg, AI, Si, Ca, Ti, V, Cr, Fe, Co, Ni, Cu, Zn, Y, Zr, Nb et Mo, avec 0,8≤x≤1,2 ; 0≤y≤0,6 ; 0,0≤z≤0,2,
iii) un composé de formule LiₓMn_{2-y-}zNi_{y}M_{z}O_{4-d-c}F_{c} où M représente un ou plusieurs éléments choisis dans le groupe consistant en B, Mg, AI, Si, Ca, Ti, V, Cr, Fe, Co, Cu, Zn, Y, Zr, Nb, Ru, W et Mo;. et 1≤x≤1,4 ; 0<y≤0,6 ; 0≤z≤0,2 ; 0≤d≤1 ; 0≤c≤1,
iv) un composé de formule LiₓMn_{2-y-z}M'_{y}M"_{z}O₄, où M' et M" sont choisis dans le groupe consistant en B, Mg, AI, Si, Ca, Ti, V, Cr, Fe, Co, Ni, Cu, Zn, Y, Zr, Nb et Mo ;. M' et M" étant différents l'un de l'autre, et 1≤x≤1,4 ; 0≤y≤0,6 ; 0≤z≤0,2, et
v) un composé de formule LiVPO₄F.

La matière active anodique n'est pas particulièrement limitée. Elle est un matériau capable d'insérer du lithium dans sa structure. Elle peut être choisie parmi des composés du lithium, des matériaux carbonés comme le graphite, le coke, le noir de carbone et le carbone vitreux. Elle peut aussi être à base d'étain, de silicium, de composés à base de carbone et de silicium, de composés à base de carbone et d'étain ou de composés à base de carbone, d'étain et de silicium. Elle peut aussi être un oxyde de titane lithié tel que Li₄Ti₅O₁₂ ou un oxyde de titane de niobium tel que TiNb₂O₇.

Bien entendu, ces exemples sont non limitatifs et le procédé décrit ultérieurement pourra être utilisé pour n'importe quel type d'élément électrochimique 12, et notamment lorsque le calcul de son état de charge SOC repose classiquement sur un compteur coulométrique pouvant diverger et/ou une recalibration impliquant un temps de repos et un courant faible.

Le système de gestion 14 est un système propre à gérer l'élément électrochimique 12.

Le système de gestion 14 comporte un capteur de tension 16, un capteur de courant 18, un capteur de la température 20 et un calculateur 22.

Le capteur de tension 16 est propre à mesurer la tension aux bornes de l'élément électrochimique 12.

Le capteur de courant 18 est propre à mesurer le courant délivré par l'élément électrochimique 12.

Le capteur de température 20 est propre à mesurer la température de l'élément électrochimique 12.

Le calculateur 22 est propre à mettre en œuvre un procédé d'estimation de l'état de charge de l'élément électrochimique 12.

Le calculateur 22 est un circuit électronique conçu pour manipuler et/ou transformer des données représentées par des quantités électroniques ou physiques dans des registres du calculateur et/ou des mémoires en d'autres données similaires correspondant à des données physiques dans les mémoires de registres ou d'autres types de dispositifs d'affichage, de dispositifs de transmission ou de dispositifs de mémorisation.

En tant qu'exemples spécifiques, le calculateur 22 comprend un processeur monocœur ou multicœurs (tel qu'une unité de traitement centrale (CPU), une unité de traitement graphique (GPU), un microcontrôleur et un processeur de signal numérique (DSP)), un circuit logique programmable, comme un circuit intégré spécifique à une application (ASIC), un réseau de portes programmables *in situ* (FPGA), un dispositif logique programmable (PLD) et des réseaux logiques programmables (PLA), une machine à états, une porte logique et des composants matériels discrets.

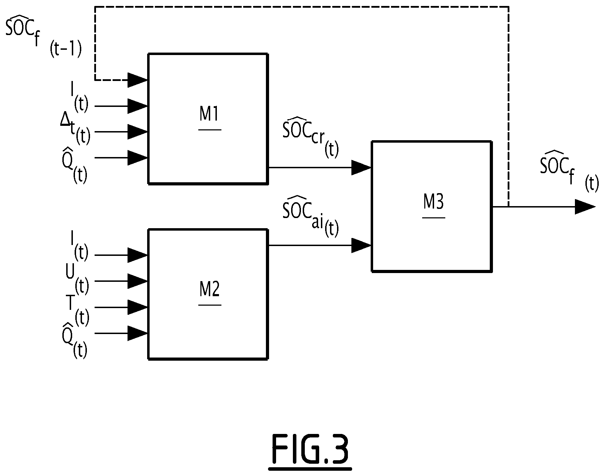

Un exemple de mise en œuvre du procédé d'estimation de l'état de charge SOC est maintenant décrit en référence à la représentation en schéma-bloc de la figure 3.

Comme cela apparaîtra à la description qui suit, le procédé comporte l'emploi de trois modèles, un premier modèle M1, un deuxième modèle M2 et un troisième modèle M3.

Un modèle est ici défini comme l'outil mathématique correspondant à une technique mesurant ou estimant une grandeur physique. La technique est ainsi une étape d'un procédé de mesure ou d'estimation prenant en entrée des mesures et donnant en sortie une valeur représentative de la grandeur physique alors que le modèle prend en entrée des valeurs numériques pour sortir d'autres valeurs numériques. C'est la technique qui vient donner une signification physique à ces valeurs numériques.

Le procédé permet ainsi d'estimer l'état de charge SOC de l'élément électrochimique 12 à l'aide d'un modèle hybride (le troisième modèle M3) faisant intervenir d'une part un modèle de calcul de l'état de charge SOC en utilisant un comptage coulométrique (le première modèle M1) et d'autre part, un modèle calculant l'état de charge SOC en utilisant un réseau de neurones (le deuxième modèle M2). Le troisième modèle M3 sert à limiter les imprécisions sur la détermination de l'état de charge SOC liées au biais du capteur de courant 18, à l'auto-décharge de l'élément électrochimique 12 ainsi qu'au défaut de l'estimation de la capacité de l'éléments électrochimique.

Il peut être noté que, parmi ces trois modèles M1, M2 et M3, seul le deuxième modèle M2 est un réseau de neurones appris. Ainsi, le procédé d'estimation de l'état de charge SOC comporte deux phases, une phase d'apprentissage et une phase d'utilisation.

Selon l'exemple décrit, la phase d'apprentissage est mise en oeuvre hors-ligne, c'est-à-dire que la phase d'apprentissage n'est pas embarquée.

C'est lors de cette phase d'apprentissage que le deuxième modèle M2 est entraîné afin d'apprendre à estimer un état de charge à partir de profils de charge et décharge à courant constant pour différentes températures et différents états de vieillissement (plusieurs éléments ayant des capacités différentes dû au vieillissement).

Dans l'exemple décrit, la phase d'apprentissage comporte une étape d'apprentissage d'un réseau de neurones, une étape de calcul et une étape d'établissement.

Lors de l'étape d'apprentissage, le réseau de neurones est entraîné pour estimer l'état de charge SOC de l'élément électrochimique 12 à partir des valeurs de tension de l'élément électrochimique 12, de courant de l'élément électrochimique 12, de température de l'élément électrochimique 12 et de capacité Q de l'élément électrochimique 12.

Les valeurs de tension, du courant et de température proviennent respectivement du capteur de tension 16, du capteur de courant 18 et du capteur de température 20.

Selon l'exemple décrit, ces valeurs sont mesurées régulièrement.

La valeur de capacité Q est obtenue moins fréquemment et peut être obtenue par toute technique notamment par détermination lors d'une charge ou une décharge complète.

Le réseau de neurones à apprendre est un perceptron multicouche.

Un tel réseau de neurones est plus souvent désigné par l'abréviation MLP qui renvoie à la dénomination anglaise correspondante de « multilayer perceptron ».

Ainsi, un réseau de neurones est une succession ordonnée de couches de neurones dont chacune prend ses entrées sur les sorties de la couche précédente.

Plus précisément, chaque couche comprend des neurones prenant leurs entrées sur les sorties des neurones de la couche précédente.

Dans l'exemple, les couches sont denses, c'est-à-dire qu'un neurone d'une couche prend les entrées de l'ensemble des neurones de la couche précédente. L'expression anglaise de « fully connected » est parfois utilisée pour désigner ce type de couches.

Chaque couche est reliée par une pluralité de synapses. Un poids synaptique est associé à chaque synapse. C'est le plus souvent un nombre réel pouvant prendre des valeurs positives comme négatives.

Chaque neurone est propre à effectuer une somme pondérée des valeur(s) reçue(s) de la part des neurones de la couche précédente avec un biais éventuel propre à chaque neurone, chaque valeur étant alors multipliée par le poids synaptique respectif, puis à appliquer une fonction d'activation, typiquement une fonction non-linéaire, à ladite somme pondérée, et à délivrer aux neurones de la couche suivante la valeur résultat de l'application de la fonction d'activation. La fonction d'activation permet d'introduire une non-linéarité dans le traitement effectué par chaque neurone. La fonction sigmoïde, la fonction tangente hyperbolique, la fonction de Heaviside sont des exemples de fonctions d'activation.

Le réseau de neurones à apprendre est un réseau de neurones facilement embarquable.

Aussi, il convient que le réseau de neurones présente un nombre de neurones limités.

Par exemple, le nombre total du réseau de neurones est de l'ordre de plusieurs dizaines de neurones, au maximum une centaine de neurones.

Dans l'exemple décrit, le réseau de neurones comprend plusieurs couches, à savoir une couche d'entrée, une ou plusieurs couche(s) cachée(s) et une couche de sortie.

Le réseau de neurones est appris par utilisation d'une technique d'apprentissage supervisée.

Ainsi, il s'agit d'apprendre les paramètres libres du réseau de neurones à partir d'un jeu de données obtenu par des expériences réelles en laboratoire, typiquement pour un nombre compris entre 20 et 40 d'éléments électrochimiques différents.

Durant ces expériences, des éléments électrochimiques 12 subissent des cycles successifs et les valeurs électriques de ces éléments électrochimiques 12 (courant, tensions, état de charge SOC, capacité) et les valeurs de température sont relevées pour former le jeu de données.

Le jeu de données est ensuite séparé en jeu d'entraînement et jeu de test, selon par exemple une proportion de 80%-20%.

Le jeu d'entraînement est utilisé pour que le réseau de neurones apprenne ses différents paramètres libres par itérations successives jusqu'à vérifier un critère de performance souhaitée. Il est ainsi obtenu un réseau de neurones appris.

Le jeu de test sert ensuite à évaluer la performance du réseau de neurones appris.

Le réseau de neurones constitue ainsi, pour l'élément électrochimique 12, un deuxième modèle M2 estimant une valeur de l'état de charge SOC à partir des valeurs de tension, de courant, de température et de capacité.

Le deuxième modèle M2 est plutôt robuste aux biais de courant même forts, de par sa structure basée sur un perceptron multicouche qui est sans effet mémoire, c'est-à-dire qui utilise uniquement les valeurs courantes et non les valeurs antérieures pour obtenir l'estimation souhaitée.

En outre, du fait de sa faible dimension, le deuxième modèle M2 est facilement embarquable car son empreinte mémoire et son empreinte processeur sont réduites.

Néanmoins, cela entraîne qu'un tel deuxième modèle M2 présente une erreur d'estimation, c'est-à-dire un écart entre la valeur estimée et la valeur réelle, relativement importante dans certaines conditions.

Le réseau de neurones du deuxième modèle M2 est chargée sur une mémoire du calculateur 22.

Le calculateur 22 est ainsi prêt pour mettre en œuvre la phase d'utilisation.

Au contraire de la phase d'apprentissage qui est effectuée une seule fois, la phase d'utilisation est mise en œuvre pour une pluralité d'instants.

En particulier, la phase d'utilisation correspond à une phase d'utilisation en temps réel de la batterie 10.

Par exemple, les instants sont équirépartis, par exemple espacés d'un intervalle de temps compris entre 100 millisecondes (ms) et 2 secondes (s).

Selon un autre exemple, la durée entre deux instants n'est pas constante.

Les étapes de la phase d'utilisation sont mises en œuvre pour chaque instant.

En ce sens, il peut ainsi être considéré que la phase d'utilisation est itérative et qu'à chaque instant de mise en œuvre, une itération a lieu.

Selon l'exemple décrit, la phase d'utilisation est mise en œuvre en ligne, c'est-à-dire que la phase d'utilisation est embarquée et donc mise en œuvre par le calculateur 22.

La phase d'utilisation comporte une étape d'obtention, une étape de calcul, une étape de détermination du seuil, une étape de comparaison, une étape de détermination de la valeur estimée de l'état de charge.

Lors de l'étape d'obtention, le calculateur 22 obtient des mesures (valeurs) de la tension U, du courant I de la température T et la capacité Q de l'élément électrochimique 12.

Lors de l'étape de calcul, le calculateur 22 calcule la valeur de l'état de charge SOC selon deux techniques distinctes correspondant aux premier modèle M1 et deuxième modèle M2.

Selon une première technique, le calculateur 22 réalise la technique dite coulométrique présentée précédemment.

Cette technique repose sur le fait que l'état de charge SOC d'un élément électrochimique 12 dépend directement du ratio entre la quantité de charge accumulée (ou comptage des Ampères-heures en référence à l'unité souvent utilisée pour cette quantité) et la capacité de l'élément électrochimique 12.

Ainsi, le calculateur 22 utilise alors les valeurs de courant et la valeur de la capacité selon la formule suivante : ${\hat{SOC}}_{{f}_{\left(t\right)}} = {\hat{SOC}}_{{f}_{\left(t-1\right)}} + \frac{{\int }_{t - 1}^{t} I \times dt}{Q}$ Où :
- *t -* 1 désigne un instant antérieur,
- ${\hat{SOC}}_{{f}_{\left(t\right)}}$ désigne la valeur estimée de l'état de charge SOC obtenue à l'instant présent *t*, et
- ${\hat{SOC}}_{{f}_{\left(t-1\right)}}$ désigne la valeur estimée de l'état de charge SOC obtenue à l'instant antérieur *t* - 1.

Plus précisément, la première technique comporte trois opérations, une opération d'obtention, une opération de calcul et une opération de déduction.

Lors de l'opération d'obtention, le calculateur 22 obtient une valeur estimée ${\hat{SOC}}_{{f}_{\left(t-1\right)}}$ de l'état de charge SOC, cette valeur ayant été obtenue à un instant antérieur *t* - 1.

Puis, lors de l'opération de calcul, le calculateur 22 calcule la valeur de la quantité de charge accumulée depuis l'instant antérieur *t* - 1 par utilisation des valeurs du courant obtenues.

Cette quantité de charge accumulée *ΔAh*_{(*t*)} est le différentiel en ampère heure par rapport à l'instant antérieur *t* - 1 selon la relation : ${ΔAh}_{\left(t\right)} = \frac{{I}_{\left(t\right)} ∗ {Δ}_{{t}_{\left(t\right)}}}{3600}$

Dans cette relation, *Δ*_{*t*(*t*)} désigne la durée de l'intervalle de temps écoulé depuis l'instant antérieur *t* - 1.

Le calculateur 22 déduit ensuite une première valeur calculée de l'état de charge par calcul de la somme de la valeur estimée de l'état de charge SOC obtenue et du ratio de la valeur de la quantité de charge accumulée entre l'instant antérieur *t* - 1 et l'instant actuel t et de la valeur estimée de la capacité *Q̂*_{(*t*)} de l'au moins un élément électrochimique.

En notant la première valeur calculée ${\hat{SOC}}_{{cr}_{\left(t\right)}}$*,* il vient ainsi : ${\hat{SOC}}_{{cr}_{\left(t\right)}} = {\hat{SOC}}_{{f}_{\left(t-1\right)}} + \frac{{ΔAh}_{\left(t\right)} ∗ 100}{{\hat{Q}}_{\left(t\right)}} = {\hat{SOC}}_{{f}_{\left(t-1\right)}} + \frac{\frac{{I}_{\left(t\right)} ∗ {Δ}_{{t}_{\left(t\right)}}}{3600} ∗ 100}{{\hat{Q}}_{\left(t\right)}}$

Le calculateur 22 obtient ainsi une valeur de l'état de charge SOC selon la première technique, c'est-à-dire la première valeur calculée ${\hat{SOC}}_{{cr}_{\left(t\right)}}$.

Selon la deuxième technique, le deuxième modèle d'estimation M2 permet de calculer un état de charge à partir de la mesure de la température *T*_{(*t*)}*,* de la tension *U*_{(*t*)} *,* de la capacité *Q̂*_{(*t*)} de l'élément électrochimique, ainsi que du courant *I*_{(*t*)} qui est appliqué à l'élément électrochimique 12.

Autrement formulé, le calculateur 22 applique le deuxième modèle d'estimation M2 sur la valeur de tension U, la valeur de courant I, la valeur de température T et la valeur de la capacité Q obtenues lors de l'étape d'obtention au même instant d'obtention.

Cela revient à réaliser une inférence grâce au réseau de neurones appris hors ligne pour obtenir une valeur de l'état de charge SOC.

Le calculateur 22 obtient ainsi une valeur de l'état de charge SOC selon la deuxième technique, notée deuxième valeur calculée ${\hat{SOC}}_{{ai}_{\left(t\right)}}$.

A l'issue de l'étape de calcul, le calculateur 22 dispose ainsi de deux valeurs distinctes de l'état de charge SOC de l'élément électrochimique 12, à savoir ${\hat{SOC}}_{{cr}_{\left(t\right)}}$ et ${\hat{SOC}}_{{ai}_{\left(t\right)}}$*.*

Lors de l'étape de détermination du seuil S, le calculateur 22 détermine le seuil S.

Ce seuil S dépend du biais de courant maximal *I*_{*bias_max*(*t*)}*,* c'est-à-dire des différentes contributions aux imperfections de la détermination de l'état de charge SOC liées au fait que le courant va dériver au cours du temps.

Pour déterminer cette valeur du biais de courant maximal *I*_{*bias_max*(*t*)}*,* il est possible de prendre en compte une ou plusieurs contributions.

Une première contribution au biais de courant provient des imperfections du capteur de courant 18 fournissant les valeurs de courant. Cette première contribution est notée *I*_{*biais_capteur*_*max*(*t*)}.

Une deuxième contribution au biais de courant provient d'un phénomène physique, c'est l'autodécharge de l'élément électrochimique 12. Cette deuxième contribution est notée *I*_{*autodécharge*_*max*(*t*)}.

Une troisième contribution au biais de courant provient des erreurs sur l'estimation de la capacité de l'élément électrochimique 12. Cette troisième contribution est notée *I*_{*biais_capacité_max*(*t*)}.

La troisième contribution provient de l'erreur d'estimation de la capacité lors de l'obtention de cette dernière (par exemple lors d'un cycle de maintenance en faisant une décharge complète et en comptant les Ampère heure), le résultat obtenu est précis à une quantité d'Ampère heure près (la quantité pouvant entre négative ou positive). Cette quantité en Ampère heures peut être ramenée à un courant comme si l'élément électrochimique 12 se déchargeait à un courant supérieur ou inférieur de ce qui est mesuré par le capteur de courant 18.

Par exemple, en partant d'un état de charge de 100%, une décharge complète à un courant donné va conduire à atteindre l'état de charge de 0% plus tôt si la capacité est sous-estimée ou plus tard si la capacité est surestimée, ce qui peut être ramené à un différentiel de courant (biais) qui correspond à *I*_{*biais_capacité_max*(*t*)}*.*

Lorsque les trois contributions sont prises en compte, il vient la relation suivante : ${I}_{bias _ max \left(t\right)} = \left|{I}_{biais _ capteur _ max \left(t\right)}\right| + \left|{I}_{autod é charge _ max \left(t\right)}\right| + \left|{I}_{biais _ capacit é_ max \left(t\right)}\right|$

Chacune des trois contributions sont, par exemple, connues par des données provenant du constructeur.

Dans l'exemple décrit, le calculateur 22 détermine le seuil S comme le rapport entre la valeur de quantité de charge susceptible d'être accumulée depuis l'instant antérieur du fait du biais de courant maximal et la valeur de la capacité de l'élément électrochimique 12.

Il vient ainsi que le seuil S est ici un équivalent en état de charge de la valeur du biais de courant maximal, c'est-à-dire que : $S = {ΔSOC}_{bias _ max \left(t\right)} = \frac{{ΔAh}_{bias _ max \left(t\right)} ∗ 100}{{\hat{Q}}_{\left(t\right)}}$

Dans cette expression, *ΔAh*_{*bias_max*(*t*)} désigne le différentiel en Ampère heure, cette quantité pouvant se calculer à partir du biais de courant maximal *I*_{*bias_max*(*t*)} et du temps écoulé *Δ*_{*t*(*t*)} depuis la précédente estimation (exprimé en seconde) comme suit : ${ΔAh}_{bias _ max \left(t\right)} = \frac{{I}_{bias _ max \left(t\right)} ∗ {Δ}_{{t}_{\left(t\right)}}}{3600}$

De ce fait, le seuil S peut s'exprimer comme : $S = \frac{\frac{{I}_{bias _ max \left(t\right)} ∗ {Δ}_{{t}_{\left(t\right)}}}{3600} ∗ 100}{{\hat{Q}}_{\left(t\right)}}$

Lors de l'étape de comparaison, le calculateur 22 compare deux grandeurs, à savoir d'une part la différence en valeur absolue entre la deuxième valeur calculée et la première valeur calculée $\left|{\hat{SOC}}_{{ai}_{\left(t\right)}}-{\hat{SOC}}_{{cr}_{\left(t\right)}}\right|$ *et* d'autre part la valeur absolue du seuil S calculé à l'étape précédente.

La comparaison permettra ainsi de déterminer deux cas :
- un premier cas selon lequel la différence en valeur absolue entre la deuxième valeur calculée ${\hat{SOC}}_{{ai}_{\left(t\right)}}$ et la première valeur calculée ${\hat{SOC}}_{{cr}_{\left(t\right)}}$ est inférieure ou égale au seuil S, c'est-à-dire : $\left|{\hat{SOC}}_{{ai}_{\left(t\right)}}-{\hat{SOC}}_{{cr}_{\left(t\right)}}\right| \leq \left|{ΔSOC}_{{MaxBias}_{\left(t\right)}}\right|$
- un deuxième cas selon lequel la différence en valeur absolue entre la deuxième valeur calculée ${\hat{SOC}}_{{ai}_{\left(t\right)}}$ et la première valeur calculée ${\hat{SOC}}_{{cr}_{\left(t\right)}}$ est strictement supérieure au seuil S, c'est-à-dire : $\left|{\hat{SOC}}_{{ai}_{\left(t\right)}}-{\hat{SOC}}_{{cr}_{\left(t\right)}}\right| > \left|{ΔSOC}_{{MaxBias}_{\left(t\right)}}\right|$

Lors de l'étape de détermination, le calculateur 22 détermine la valeur estimée de l'état de charge ${\hat{SOC}}_{{f}_{\left(t\right)}}$ différemment selon le cas obtenu à l'étape de comparaison.

Lorsque le calculateur 22 est en présence du premier cas, le calculateur 22 détermine la valeur estimée de l'état de charge ${\hat{SOC}}_{{th}_{\left(t\right)}}$ comme étant la deuxième valeur calculée ${\hat{SOC}}_{{ai}_{\left(t\right)}} ,$*,* ce qui s'écrit mathématiquement comme : ${\hat{SOC}}_{{f}_{\left(t\right)}} = {\hat{SOC}}_{{ai}_{\left(t\right)}}$

Lorsque le calculateur 22 est en présence du deuxième cas, le calculateur 22 détermine la valeur estimée de l'état de charge ${\hat{SOC}}_{{f}_{\left(t\right)}}$ comme étant la somme de la première valeur calculée de l'état de charge ${\hat{SOC}}_{{cr}_{\left(t\right)}}$ et d'un facteur de correction proportionnel au seuil S.

En l'espèce, le facteur de correction est égal au produit d'un coefficient, d'une valeur de direction et du seuil, à savoir : ${f}_{corr} = C ∗ S ∗ D$ où :
- *f_{corr}* désigne le facteur de correction,
- *D* désigne la valeur de direction, cette valeur étant égale au rapport entre la différence de la deuxième valeur calculée ${\hat{SOC}}_{{ai}_{\left(t\right)}}$ et la première valeur calculée ${\hat{SOC}}_{{cr}_{\left(t\right)}}$ et la valeur absolue de la différence de la deuxième valeur calculée ${\hat{SOC}}_{{ai}_{\left(t\right)}}$ et la première valeur calculée ${\hat{SOC}}_{{cr}_{\left(t\right)}}$*,* ce qui s'écrit mathématiquement comme : $D = \frac{{\hat{SOC}}_{{ai}_{\left(t\right)}} - {\hat{SOC}}_{{cr}_{\left(t\right)}}}{\left|{\hat{SOC}}_{{ai}_{\left(t\right)}}-{\hat{SOC}}_{{cr}_{\left(t\right)}}\right|}$ la valeur de direction *D* prenant ainsi deux valeurs +1 ou -1, et
- C désigne un coefficient, qui est avantageusement compris entre 1 et 2 et est adapté en fonction des conditions d'utilisation du procédé (voir l'exemple de l'initialisation décrit ci-après).

Compte-tenu de ces définitions, le facteur de correction *f_{corr}* vérifie la relation mathématique suivante : ${f}_{corr} = \frac{{\hat{SOC}}_{{ai}_{\left(t\right)}} - {\hat{SOC}}_{{cr}_{\left(t\right)}}}{\left|{\hat{SOC}}_{{ai}_{\left(t\right)}}-{\hat{SOC}}_{{cr}_{\left(t\right)}}\right|} ∗ C ∗ {ΔSOC}_{{MaxBias}_{\left(t\right)}}$

Pour les valeurs avantageuses du coefficient C, à savoir que le coefficient C est compris entre 1 et 2, cela signifie que : ${ΔSOC}_{{MaxBias}_{\left(t\right)}} \leq \left|{f}_{corr}\right| \leq 2 ∗ {ΔSOC}_{{MaxBias}_{\left(t\right)}}$

Le fonctionnement qui vient d'être décrit implique une rétroaction avec un instant antérieur qui sera généralement l'instant précédent.

Il se pose alors la question de comment fixer les valeurs au premier instant puisqu'aucune valeur n'a été estimée à l'instant précédent.

Pour cela, le présent procédé propose une étape d'initialisation.

Lors de l'étape d'initialisation, le calculateur 22 fixe la capacité initiale de l'élément électrochimique 12 et la valeur estimée initiale de l'état de charge de l'élément électrochimique 12.

Dans ce qui suit, la capacité initiale de l'élément électrochimique 12 est notée *Q̂*_{(*t*=0)} ou *Qᵢₙᵢₜ* et similairement, la valeur estimée initiale de l'état de charge de l'élément électrochimique 12 est notée ${\hat{SOC}}_{{f}_{\left(t=0\right)}}$ ou *SOCᵢₙᵢₜ.*

La capacité initiale *Qᵢₙᵢₜ* est obtenue par le calculateur 22 par une estimation provenant par exemple d'un modèle connu ou par une donnée prédéfinie.

En ce qui concerne la valeur estimée initiale de l'état de charge *SOCᵢₙᵢₜ,* le calculateur 22 choisit soit des valeurs prédéfinies soit la deuxième valeur calculée ${\hat{SOC}}_{{ai}_{\left(t\right)}}$ (ce qui implique que la première technique sera mise en oeuvre après la deuxième technique dans ce cas).

Plus précisément, dans l'exemple décrit, le calculateur 22 choisit :
- une valeur de 100% après un cycle de maintenance se terminant par une charge complète,
- la deuxième valeur calculée ${\hat{SOC}}_{{ai}_{\left(t\right)}}$ lorsque l'élément électrochimique 12 n'est pas en train de subir un épisode de consigne de courant trop dynamique. Il peut être considéré que le courant ne présente plus de caractère dynamique à partir du moment que la tension de l'élément électrochimique 12 a atteint un régime établi. Une telle valeur est généralement fournie par le constructeur de l'élément électrochimique 12,
- la valeur donnée par la tension à condition d'une consigne de courant faible et d'un certain temps de repos de l'élément électrochimique 12, ces données de courant faible et de temps de repos étant également fournies par le constructeur de l'élément électrochimique 12, et
- une valeur de 50% sinon.

Même si la valeur estimée initiale de l'état de charge *SOCᵢₙᵢₜ* est mauvaise, il est possible de corriger rapidement la valeur estimée en augmentant la valeur du coefficient C, pour qu'elle ait une valeur bien supérieure à 2, par exemple 5. La valeur du coefficient C sera ensuite ramenée dans l'intervalle privilégié (entre 1 et 2 ici) pour garantir une bonne précision de l'estimation de l'état de charge SOC.

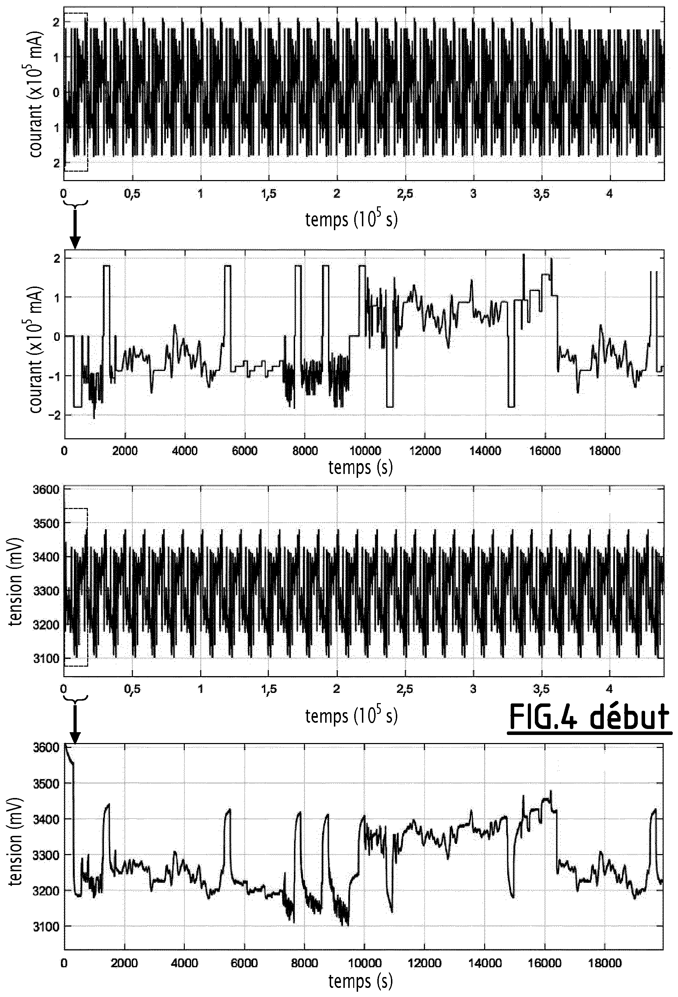

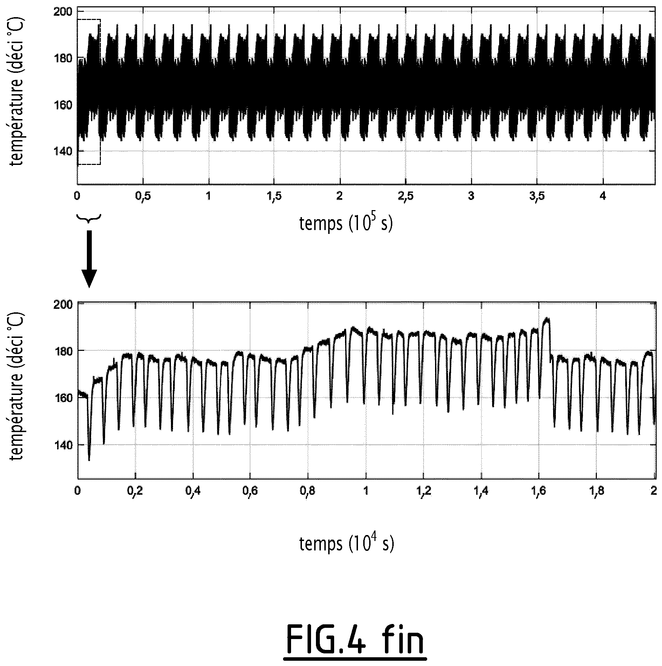

Il est maintenant illustré en référence aux figures 4 à 7 des exemples de mise en oeuvre expérimentale du procédé qui vient d'être décrit par la demanderesse.

Les figures 4 présentent les données d'entrée, à savoir le courant dynamique sur 440 000 secondes (5,1 jours), la tension de l'élément électrochimique 12 et la température de l'élément électrochimique 12.

Dans chacun des cas, la courbe totale est présentée et un agrandissement d'une partie de cette courbe totale.

En outre, la capacité est la capacité mesurée Q, à savoir 196 Ah dans cet exemple.

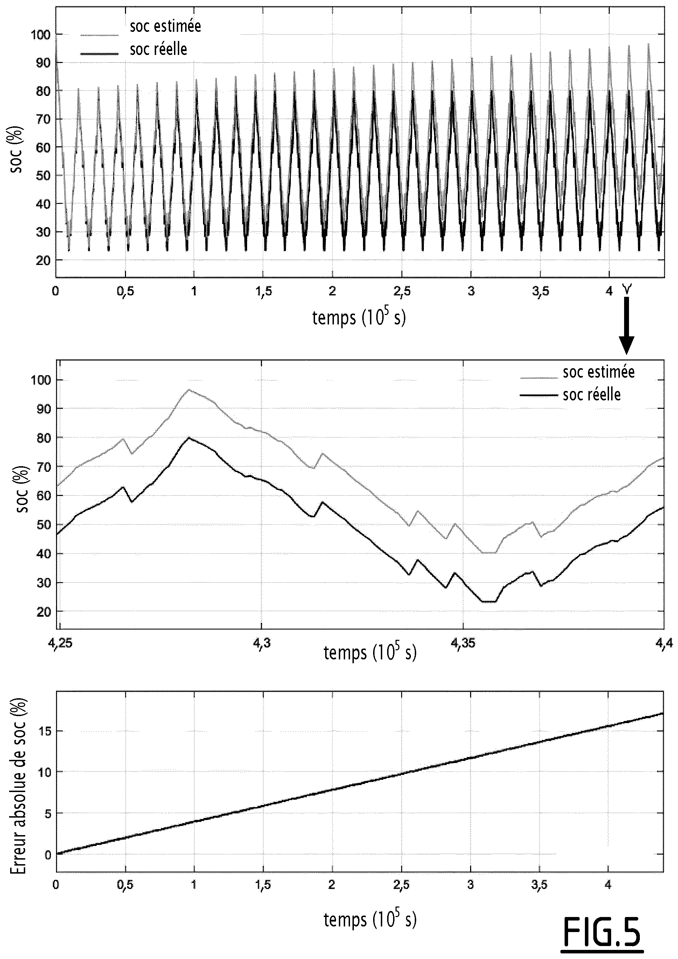

La figure 5 présente les résultats obtenus par mise en oeuvre d'une technique coulométrique.

Dans cas, il est injecté artificiellement un biais de courant de 300 mA. Cette injection se fait par l'ajout de ce biais à la valeur expérimentale mesurée. La valeur de 300 mA a été choisie car elle correspond à un biais classique pour les capteurs de courant
Le biais de courant de 300 mA est injecté pendant les 440 000 secondes de l'expérience et il est supposé que l'état de charge initial est juste.

En haut, sur la figure 5, il est représenté la variation temporelle de la valeur réelle de l'état de charge et de la valeur obtenue par mise en oeuvre de la technique coulométrique. Comme précédemment, cette variation est représentée sur la totalité du graphe mais aussi sur une partie agrandie.

En bas de la figure 5, c'est l'erreur d'estimation sur l'état de charge qui est représentée. Cette erreur augmente linéairement avec le temps et vaut 18,7% au bout de 440000 secondes (5,1 jours).

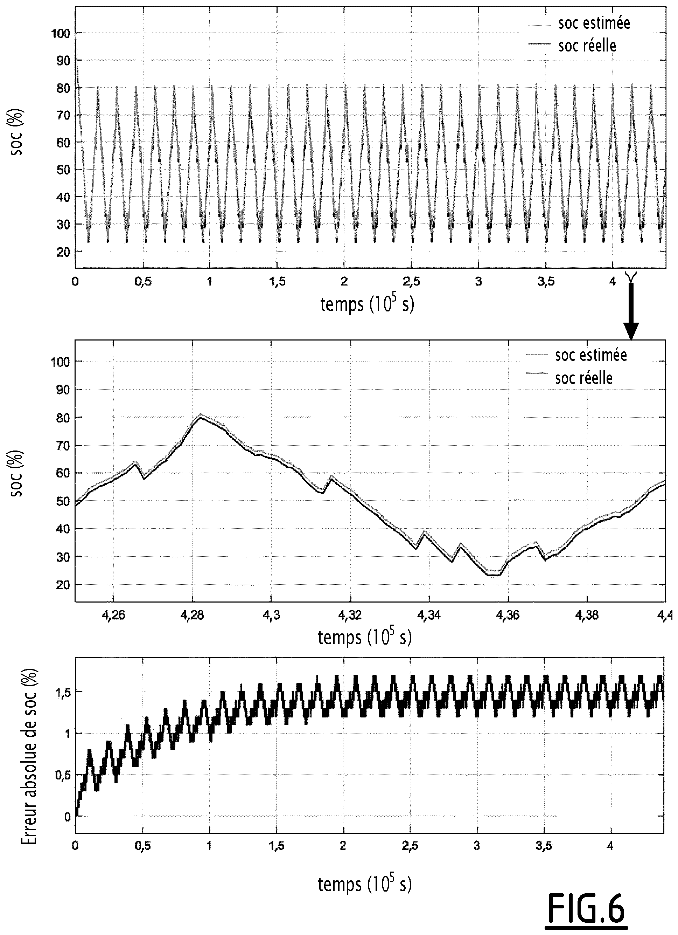

La figure 6 présente les résultats obtenus par mise en œuvre du procédé de la figure 3. Les hypothèses sont les mêmes que pour le cas de la figure 5.

En haut, sur la figure 6, il est représenté la variation temporelle de la valeur réelle de l'état de charge et de la valeur obtenue par mise en œuvre du procédé de la figure 3. Comme précédemment, cette variation est représentée sur la totalité du graphe mais aussi sur une partie agrandie.

En bas de la figure 6, c'est l'erreur d'estimation sur l'état de charge qui est représentée. Cette erreur reste toujours contenue et vaut au maximum 1,7%. Le gain est manifeste par rapport au cas illustré sur la figure 5.

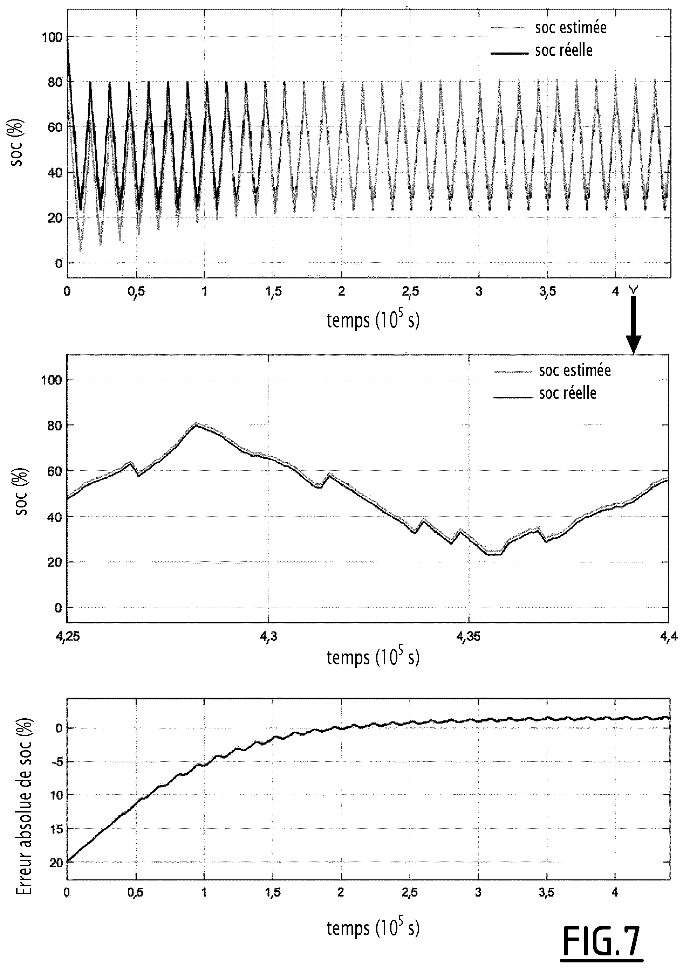

La figure 7 présente les résultats obtenus par mise en œuvre du procédé de la figure 3. Les hypothèses sont les mêmes que pour le cas de la figure 5 sauf qu'il est supposé qu'une erreur dans la valeur initiale de l'état de charge est présente (ici 20% d'erreur).

Les courbes représentées sont les mêmes courbes que pour la figure 6. Il peut être observé que l'erreur est peu à peu compensée et atteint à la fin des 440 000 secondes la valeur de 1,7%.

Un tel procédé permet donc d'estimer la valeur de l'état de charge SOC de l'élément électrochimique 12 avec une meilleure précision.

En effet, le procédé correspond à l'utilisation d'un modèle hybride utilisant deux techniques distinctes : une première technique issue du monde de la mesure et basée sur un comptage coulométrique et une deuxième technique issue du monde de l'apprentissage machine basée sur l'application d'un réseau de neurones.

Le procédé qui vient d'être décrit repose sur un effet de boussole.

Avec cette analogie, la deuxième valeur calculée ${\hat{SOC}}_{{ai}_{\left(t\right)}}$ sert de direction de référence et la force avec laquelle il faut modifier la première valeur calculée ${\hat{SOC}}_{{cr}_{\left(t\right)}}$ est proportionnelle à la valeur du biais de courant maximal *I*_{*bias_max*(*t*)}*.*

Le procédé peut ainsi être interprété comme une correction de la technique coulométrique par l'effet de boussole.

Il convient de noter que ce gain en précision est obtenu avec un surcoût calculatoire relativement faible car le réseau de neurones utilisé présente une empreinte mémoire très restreinte (peu de neurones). Cela entraîne que le gain en précision reste compatible avec une application embarquée.

Par ailleurs, le procédé permet également d'effectuer une recalibration permanente de la première technique alors que l'élément électrochimique 12 est en utilisation usuelle, même dans la portion plane Z23. Cela permet ainsi à l'élément électrochimique 12 de continuer sa mission tout en ayant une bonne estimation de l'état de la charge SOC. Ceci a pour conséquence une meilleure disponibilité de l'élément électrochimique 12 et/ou d'éviter le surdimensionnement de la batterie 10.

D'autres modes de réalisation bénéficiant des avantages précités sont également envisageables.

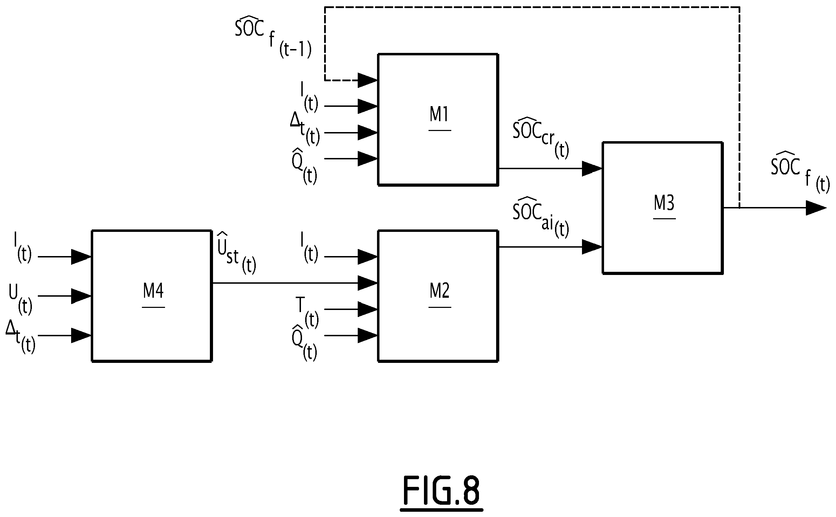

Un autre mode de réalisation est notamment décrit à la figure 8.

Dans cette figure 8, il apparaît que le procédé d'estimation repose sur les trois modèles M1, M2 et M3 précités et un quatrième modèle M4.

Le quatrième modèle M4 est un modèle de prétraitement d'une entrée du deuxième modèle M2.

Plus précisément, au lieu de fournir la tension de l'élément électrochimique 12 en entrée du deuxième modèle M2, le quatrième modèle M4 vient fournir une valeur estimée de la valeur de la tension en régime établi *Û*_{*st*(*t*)} à l'instant d'obtention.

Pour cela, le quatrième modèle M4 est un modèle propre à estimer la valeur de la tension en régime établi *Û*_{*st*(*t*)} à partir de la valeur de tension *U*_{(*t*)} de l'élément électrochimique 12 à l'instant d'obtention, la valeur de courant *I*_{(*t*)} de l'élément électrochimique 12 à l'instant d'obtention et le temps écoulé *Δ*_{*t*_{(*t*)}} depuis l'instant antérieur.

Le quatrième modèle M4 est un modèle électrique équivalent du système.

En l'occurrence, il s'agit ici d'un modèle électrique de type RC du premier ordre de l'élément électrochimique 12. Autrement formulé, l'élément électrochimique 12 est assimilé à une première résistance en série avec un composant, le composant étant formé d'une deuxième résistance et d'un condensateur. Les valeurs de résistance et de capacité de ces éléments sont des données du constructeur.

Ainsi, dans ce cas, le procédé comporte, en outre, une étape d'estimation de la valeur de la tension en régime établi *Û*_{*st*(*t*)} à l'instant d'obtention par utilisation d'un modèle d'estimation de la tension en régime établi qui est ici le quatrième modèle M4 en phase d'inférence.

Le quatrième modèle M4 permet de compenser le fait que le deuxième modèle M2 est moins performant avec une tension de l'élément électrochimique 12 fortement dynamique.

Cette moins bonne performance provient ici du fait que le deuxième modèle M2 a été entraîné par des données d'entraînement obtenues sous courants constants.

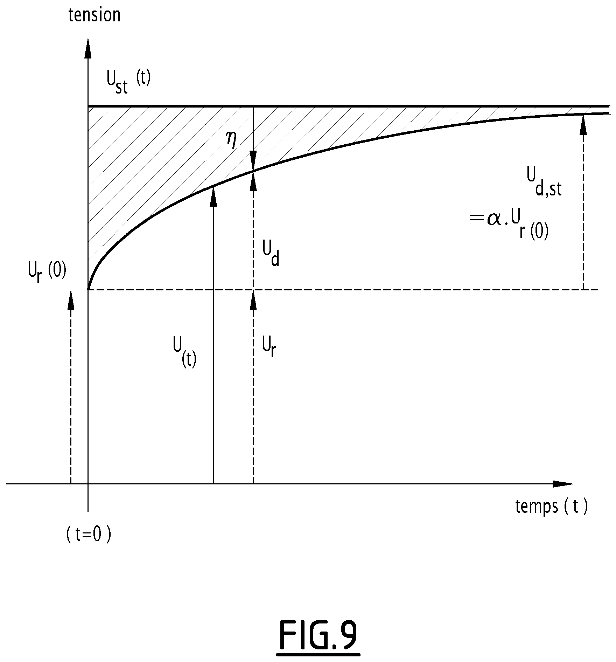

De fait, lors d'un changement brutal de courant, le bloc quatrième modèle M4 va générer une tension *Û*_{*st*(*t*)} qui est liée à la tension *U*_{(*t*)} et à la surtension *η*_{(*t*)}*,* comme visible sur la figure 9. Cette surtension *η*_{(*t*)} correspond aux effets dynamiques de la tension *U*_{(*t*)} liés à un changement brutal du courant. Retirer cette tension permet d'obtenir une tension lissée proche d'un régime à courant constant.

Ainsi le quatrième modèle M4 ajoute l'équivalent d'une surtension dynamique basée sur la physique d'un condensateur. Cette addition est soumise à un seuil de déclenchement en différentiel de courant, c'est-à-dire au respect de la condition Δ*I*_{(*t*)} *> I_{S}.*

Ce qui vient d'être décrit est maintenant précisé dans ce qui suit.

À tout moment, la tension de cellule *U*_{(*t*)} est décomposée en la somme d'un terme instantané ohmique *Uᵣ* (lié à la résistance de la cellule, donnée constructeur) et d'un terme dynamique *U_{d}* (lié à une constante de temps *τ*, donnée constructeur). Cela s'exprime mathématiquement comme : ${U}_{\left(t\right)} = {U}_{r} \left(t\right) + {U}_{d} \left(t\right)$

Sous un courant constant *I*_{(*t=*0)} (celui relevé au seuil de déclenchement), le terme de tension dynamique tend vers une valeur fixe *U_{d,st}* à l'infini.

Il peut alors être défini la surtension *η* comme la différence entre ce terme à l'infini *U_{d,st}* et le terme dynamique *U_{d}*.

Une variation de courant vérifiant *ΔI*_{(*t*)} > *I_{S}* déclenche l'activation du quatrième modèle M4. Dès lors, l'évolution temporelle de la surtension va être estimée à partir des paramètres retenus à ce seuil, à savoir le courant *I*_{(*t=*0)} et la tension *U*_{*r*(*t=*0)}*.*

La variation temporelle de *U*_{*d*(*t*)} est alors estimée via un modèle électrique équivalent RC de l'élément électrochimique 12 dont l'équation discrétisée est : ${U}_{d \left(t\right)} = \frac{{U}_{d , st} - {U}_{d \left(t-1\right)}}{τ} . Δ {t}_{\left(t\right)} + {U}_{d \left(t-1\right)}$ Où:
- *τ* est la constante de temps de l'élément électrochimique 12 dans le modèle équivalent RC, et
- *U_{d,st} = α. U*_{*r*(*t=*0)} avec *α* une constante qui est le ratio entre la tension dynamique à l'infini et la tension seuil. Ce ratio est supposé constant, dépendant des caractéristiques de l'élément électrochimique 12. La constante *α* est ainsi donnée par le constructeur de l'élément électrochimique 12.

La surtension *η*_{(*t*)} s'écrit alors comme : ${η}_{\left(t\right)} = {U}_{d \left(t\right)} - α . {U}_{r \left(t=0\right)}$

Après un certain temps (=3.*τ*), la surtension *η*_{(*t*)} tend vers 0 et est considérée comme nulle. Le quatrième modèle M4 est alors désactivé. La tension envoyée au deuxième modèle M2 est alors *U*_{(*t*)} et non *Û*_{*st*(*t*)}.

Il peut être indiqué que le quatrième modèle M4 est activé lorsqu'un seuil de différence en courant entre l'instant t et l'instant antérieur est atteint. Là encore, ce seuil fait partie des données du constructeur.

Connaissant l'expression de la surtension, la tension en sortie de bloc *Û*_{*st*(*t*)} est estimée comme : ${\hat{U}}_{{st}_{\left(t\right)}} = {U}_{\left(t\right)} - {η}_{\left(t\right)}$

Cette valeur de tension *U*_{*st*(*t*)} approchée par cette méthode permet de tendre vers une valeur de tension sous un courant constant, situation pour laquelle le deuxième modèle M2 est spécifiquement entraîné.

Ainsi les parties dynamiques liées à un changement brutal d'un courant sont compensées par l'emploi du quatrième modèle M4.

Dans ce mode de réalisation, il est ainsi obtenu une meilleure estimation de l'état de charge ${\hat{SOC}}_{{ai}_{\left(t\right)}}$, ce qui améliore la correction par effet boussole du procédé d'estimation.

Dans chacun des modes de réalisation, le deuxième modèle M2 prend ainsi en entrée une valeur de tension dépendant de la valeur obtenue de tension de l'élément électrochimique 12 au même instant d'obtention.

Dans le mode de réalisation de la figure 3, la valeur de tension dépendant de la valeur obtenue de tension de l'élément électrochimique 12 au même instant d'obtention est la valeur obtenue de tension de l'élément électrochimique 12 au même instant d'obtention.

Dans le mode de réalisation de la figure 8, la valeur de tension dépendant de la valeur obtenue de tension de l'élément électrochimique 12 au même instant d'obtention est la valeur estimée de tension en régime établi.

Il peut aussi être considéré d'autres modes de réalisation.

En particulier, le coefficient C peut être un coefficient dynamique, notamment entre 1 et 2 qui détermine l'intervalle avantageux d'excursion du coefficient C.

En ce qui concerne le seuil, il peut aussi être envisagé des seuils prédéfinis, par exemple en choisissant un majorant des valeurs possibles de S en fonction de l'utilisation de l'élément électrochimique 12.

Dans chacun des cas, le procédé permet d'obtenir une bonne estimation de l'état de charge SOC d'au moins un élément électrochimique 12 d'une batterie 10.

## Revendications

1. Procédé d'estimation de l'état de charge (SOC) d'au moins un élément électrochimique (12) d'une batterie (10),
le procédé étant mis en oeuvre par un calculateur (22), le calculateur (22) mémorisant un modèle d'estimation de l'état de charge (M2) estimant à partir d'une valeur de tension, d'une valeur de courant, d'une valeur de température et d'une valeur de capacité de l'au moins un élément électrochimique (12) la valeur de l'état de charge (SOC) de l'au moins un élément électrochimique (12), le modèle d'estimation de l'état de charge (M2) étant un réseau de neurones appris,
le procédé comprenant, pour plusieurs instants, les étapes de :
- obtention de valeurs de la tension, du courant, de la température et de la capacité de l'au moins un élément électrochimique (12),
- calcul de la valeur de l'état de charge (SOC) de l'au moins un élément électrochimique (12) selon une première technique et une deuxième technique,
la première technique comportant les opérations suivantes :
- obtention d'une valeur estimée de l'état de charge (SOC) obtenue à un instant antérieur,
- calcul de la valeur de la quantité de charge accumulée depuis l'instant antérieur par utilisation des valeurs du courant obtenues,
- déduction d'une première valeur calculée de l'état de charge (SOC) par calcul de la somme de la valeur estimée de l'état de charge (SOC) obtenue à l'instant antérieur et du ratio de la valeur de la quantité de charge accumulée depuis l'instant antérieur et de la valeur de la capacité de l'au moins un élément électrochimique (12),
la deuxième technique comportant les opérations suivantes :
- application du modèle d'estimation de l'état de charge (M2) sur les valeurs obtenues du courant, de la température et de la capacité de l'au moins un élément électrochimique (12) au même instant d'obtention et sur une valeur de tension dépendant de la valeur obtenue de tension de l'au moins un élément électrochimique (12) au même instant d'obtention, pour obtenir une deuxième valeur calculée de l'état de charge (SOC),
le procédé étant **caractérisé en ce qu'**il comprend en outre, pour les plusieurs instants, les étapes de:
- comparaison entre la différence en valeur absolue entre la deuxième valeur calculée et la première valeur calculée et la valeur absolue d'un seuil, et
- lorsque la différence en valeur absolue entre la deuxième valeur calculée et la première valeur calculée est inférieure ou égale au seuil, détermination de la valeur estimée de l'état de charge (SOC), comme étant la deuxième valeur calculée de l'état de charge (SOC),
ou
- lorsque la différence en valeur absolue entre la deuxième valeur calculée et la première valeur calculée est strictement supérieure au seuil, détermination de la valeur estimée de l'état de charge (SOC), comme étant la somme de la première valeur calculée de l'état de charge (SOC) et d'un facteur de correction proportionnel au seuil.

2. Procédé d'estimation selon la revendication 1, dans lequel le facteur de correction est égal au produit d'un coefficient, d'une valeur de direction et du seuil, la valeur de direction étant égale au rapport entre la différence de la deuxième valeur calculée et la première valeur calculée et la valeur absolue de la différence de la deuxième valeur calculée et la première valeur calculée, le coefficient étant avantageusement comprise entre 1 et 2.

3. Procédé d'estimation selon la revendication 1 ou 2, dans lequel le seuil dépend du biais de courant maximal, le biais de courant maximal prenant en compte au moins une contribution choisie dans la liste constituée d'une première contribution provenant d'un capteur de courant fournissant les valeurs de courant, d'une deuxième contribution provenant de l'autodécharge de l'au moins un élément électrochimique (12) et d'une troisième contribution provenant des erreurs sur l'estimation de la capacité de l'au moins un élément électrochimique (12).

4. Procédé d'estimation selon la revendication 3, dans lequel le procédé comporte, en outre, une étape de détermination du seuil, le seuil étant égal au rapport entre la valeur de quantité de charge susceptible d'être accumulée depuis l'instant antérieur du fait du biais de courant maximal et la valeur de la capacité de l'au moins un élément électrochimique (12).

5. Procédé d'estimation selon l'une quelconque des revendications 1 à 4, dans lequel la valeur de tension dépendant de la valeur obtenue de tension de l'au moins un élément électrochimique (12) au même instant d'obtention est la valeur obtenue de tension de l'au moins un élément électrochimique (12) au même instant d'obtention.

6. Procédé d'estimation selon l'une quelconque des revendications 1 à 4, dans lequel le procédé comporte, en outre, une étape d'estimation de la valeur de la tension en régime établi à l'instant d'obtention, la valeur de tension dépendant de la valeur obtenue de tension de l'au moins un élément électrochimique (12) au même instant d'obtention étant la valeur estimée de tension en régime établi.

7. Procédé d'estimation selon la revendication 6, dans lequel l'étape d'estimation est mise en oeuvre par application d'un modèle d'estimation de la tension en régime établi (M4) sur la valeur de tension de l'au moins un élément électrochimique (12) à l'instant d'obtention, la valeur de courant de l'au moins un élément électrochimique (12) à l'instant d'obtention et le temps écoulé depuis l'instant antérieur.

8. Procédé d'estimation selon l'une quelconque des revendications 1 à 7, dans lequel le réseau de neurones (M2) est un perceptron multicouche.

9. Procédé d'estimation selon l'une quelconque des revendications 1 à 8, dans lequel le réseau de neurones (M2) comporte un nombre de neurones inférieur ou égal à 100.

10. Procédé d'estimation selon l'une quelconque des revendications 1 à 9, dans lequel la valeur estimée initiale de l'état de charge (SOC) est choisie parmi des valeurs prédéfinies et la deuxième valeur calculée.

11. Procédé d'estimation selon l'une quelconque des revendications 1 à 10, dans lequel l'au moins un élément électrochimique (12) présentant une caractéristique état de charge (SOC) - tension en circuit ouvert (OCV) avec une portion plane, une portion plane étant une portion dans laquelle la variation de tension en circuit ouvert (OCV) est inférieure à 30 mV pour une variation d'au moins 10% de l'état de charge (SOC).

12. Procédé d'estimation selon l'une quelconque des revendications 1 à 11, dans lequel dans lequel l'au moins un élément électrochimique (12) comprend un matériau actif cathodique choisi dans les groupes suivants ou leurs mélanges :
i) un composé de formule LiₓFe_{1-y}M_{y}PO₄ où M est choisi dans le groupe consistant en B, Mg, AI, Si, Ca, Ti, V, Cr, Mn, Co, Ni, Cu, Zn, Y, Zr, Nb et Mo; et 0,8≤x≤1,2 ; 0≤y≤0,6,
ii) un composé de formule LiₓMn_{1-y-z}M'_{y}M"_{z}PO₄, où M' et M" sont différents l'un de l'autre et sont choisis dans le groupe consistant en B, Mg, AI, Si, Ca, Ti, V, Cr, Fe, Co, Ni, Cu, Zn, Y, Zr, Nb et Mo, avec 0,8≤x≤1,2 ; 0≤y≤0,6 ; 0,0≤z≤0,2,
iii) un composé de formule LiₓMn_{2-y-}zNi_{y}M_{z}O_{4-d-c}F_{c} où M représente un ou plusieurs éléments choisis dans le groupe consistant en B, Mg, AI, Si, Ca, Ti, V, Cr, Fe, Co, Cu, Zn, Y, Zr, Nb, Ru, W et Mo;. et 1≤x≤1,4 ; 0<y≤0,6 ; 0≤z≤0,2 ; 0≤d≤1 ; 0≤c≤1,
iv) un composé de formule LiₓMn_{2-y-z}M'_{y}M"_{z}O₄, où M' et M" sont choisis dans le groupe consistant en B, Mg, AI, Si, Ca, Ti, V, Cr, Fe, Co, Ni, Cu, Zn, Y, Zr, Nb et Mo ;. M' et M" étant différents l'un de l'autre, et 1≤x≤1,4 ; 0≤y≤0,6 ; 0≤z≤0,2, et
v) un composé de formule LiVPO₄F.

13. Calculateur propre à estimer l'état de charge (SOC) d'au moins un élément électrochimique (12) d'une batterie (10),
le calculateur (22) mémorisant un modèle d'estimation de l'état de charge (M2) estimant à partir d'une valeur de tension, d'une valeur de courant, d'une valeur de température et d'une valeur de capacité de l'au moins un élément électrochimique (12) la valeur de l'état de charge (SOC) de l'au moins un élément électrochimique (12), le modèle d'estimation de l'état de charge (M2) étant un réseau de neurones appris,
le calculateur (22) étant, pour plusieurs instants, propre à:
- obtenir des valeurs de la tension, du courant, de la température et de la capacité de l'au moins un élément électrochimique (12),
- calculer la valeur de l'état de charge (SOC) de l'au moins un élément électrochimique (12) selon une première technique et une deuxième technique,
la première technique comportant les opérations suivantes :
- obtention d'une valeur estimée de l'état de charge (SOC) obtenue à un instant antérieur,
- calcul de la valeur de la quantité de charge accumulée depuis l'instant antérieur par utilisation des valeurs du courant obtenues,
- déduction d'une première valeur calculée de l'état de charge (SOC) par calcul de la somme de la valeur estimée de l'état de charge (SOC) obtenue à l'instant antérieur et du ratio de la valeur de la quantité de charge accumulée depuis l'instant antérieur et de la valeur de la capacité de l'au moins un élément électrochimique (12),
la deuxième technique comportant les opérations suivantes :
- application du modèle d'estimation de l'état de charge (M2) sur les valeurs obtenues du courant, de la température et de la capacité de l'au moins un élément électrochimique (12) au même instant d'obtention et sur une valeur de tension dépendant de la valeur obtenue de tension de l'au moins un élément électrochimique (12) au même instant d'obtention, pour obtenir une deuxième valeur calculée de l'état de charge (SOC),
le calculateur (22) étant **caractérisé en ce qu'**il est en outre, pour les plusieurs instants, propre à
- comparer la différence en valeur absolue entre la deuxième valeur calculée et la première valeur calculée et un seuil, et
- lorsque la différence en valeur absolue entre la deuxième valeur calculée et la première valeur calculée est inférieure ou égale au seuil, déterminer la valeur estimée de l'état de charge (SOC), comme étant la deuxième valeur calculée de l'état de charge (SOC),
ou
- lorsque la différence en valeur absolue entre la deuxième valeur calculée et la première valeur calculée est strictement supérieure au seuil, déterminer la valeur estimée de l'état de charge (SOC), comme étant la somme de la première valeur calculée de l'état de charge (SOC) et d'un facteur de correction proportionnel au seuil.

14. Système de gestion (14) d'au moins un élément électrochimique (12) d'une batterie (10), l'au moins un élément électrochimique (12) présentant des bornes, le système de gestion (14) comprenant :
- un capteur de tension (16) propre à mesurer la tension aux bornes dudit au moins un élément électrochimique (12),
- un capteur du courant (18) propre à mesurer le courant délivré par ledit au moins un élément électrochimique (12),
- un capteur de température (20) propre à mesurer la température dudit au moins un élément électrochimique (12), et
- un calculateur (22) selon la revendication 13.

15. Batterie comprenant :
- au moins un élément électrochimique (12), et
- un système de gestion (14) selon la revendication 14.

## Patentansprüche

1. Verfahren zur Schätzung des Ladezustands (SOC) mindestens eines elektrochemischen Elements (12) einer Batterie (10),
wobei das Verfahren durch einen Computer (22) implementiert wird, wobei der Computer (22) ein Ladezustandsschätzmodell (M2) speichert, das aus einem Spannungswert, einem Stromwert, einem Temperaturwert und einem Kapazitätswert des mindestens einen elektrochemischen Elements (12) den Wert des Ladezustands (SOC) des mindestens einen elektrochemischen Elements (12) schätzt, wobei das Ladezustandsschätzmodell (M2) ein gelerntes neuronales Netzwerk ist,
wobei das Verfahren für eine Vielzahl von Zeitpunkten die folgenden Schritte umfasst:
- Erhalten von Werten für die Spannung, den Strom, die Temperatur und die Kapazität des mindestens einen elektrochemischen Elements (12),
- Berechnen des Werts des Ladezustands (SOC) des mindestens einen elektrochemischen Elements (12) unter Verwendung einer ersten Technik und einer zweiten Technik,
wobei die erste Technik die folgenden Vorgänge umfasst:
- Erhalten eines geschätzten Werts des Ladezustands (SOC), der zu einem vorherigen Zeitpunkt erhalten wurde,
- Berechnen des Werts der seit dem vorherigen Zeitpunkt angesammelten Ladungsmenge unter Verwendung der erhaltenen Stromwerte,
- Ableiten eines ersten berechneten Werts des Ladezustands (SOC) durch Berechnen der Summe des geschätzten Werts des Ladezustands (SOC), der zum vorherigen Zeitpunkt erhalten wurde, und des Verhältnisses des Werts der seit dem vorherigen Zeitpunkt angesammelten Ladungsmenge und des Werts der Kapazität des mindestens einen elektrochemischen Elements (12),
wobei die zweite Technik die folgenden Vorgänge umfasst:
- Anwenden des Ladezustandsschätzmodells (M2) auf die für den Strom, die Temperatur und die Kapazität des mindestens einen elektrochemischen Elements (12) zum gleichen Zeitpunkt erhaltenen Werte und auf einen Spannungswert, der von dem zum gleichen Zeitpunkt für die Spannung des mindestens einen elektrochemischen Elements (12) erhaltenen Wert abhängt, um einen zweiten berechneten Ladezustandswert (SOC) zu erhalten,
wobei das Verfahren **dadurch gekennzeichnet ist, dass** es ferner für mehrere Zeitpunkte die folgenden Schritte umfasst:
- Vergleichen der Differenz im Absolutwert zwischen dem zweiten berechneten Wert und dem ersten berechneten Wert mit dem Absolutwert eines Schwellenwerts, und
- wenn die Differenz im Absolutwert zwischen dem zweiten berechneten Wert und dem ersten berechneten Wert kleiner oder gleich dem Schwellenwert ist, Bestimmen des geschätzten Werts des Ladezustands (SOC) als den zweiten berechneten Wert des Ladezustands (SOC),
oder
- wenn die Differenz im Absolutwert zwischen dem zweiten berechneten Wert und dem ersten berechneten Wert strikt größer als der Schwellenwert ist, Bestimmen des geschätzten Werts des Ladezustands (SOC) als die Summe des ersten berechneten Werts des Ladezustands (SOC) und eines zum Schwellenwert proportionalen Korrekturfaktors.

2. Verfahren zur Schätzung nach Anspruch 1, wobei der Korrekturfaktor gleich dem Produkt aus einem Koeffizienten, einem Richtungswert und dem Schwellenwert ist, wobei der Richtungswert gleich dem Verhältnis zwischen der Differenz des zweiten berechneten Werts und des ersten berechneten Werts und dem Absolutwert der Differenz des zweiten berechneten Werts und des ersten berechneten Werts ist, wobei der Koeffizient vorteilhafterweise zwischen 1 und 2 liegt.

3. Verfahren zur Schätzung nach Anspruch 1 oder 2, wobei der Schwellenwert von der maximalen Stromabweichung abhängt, wobei die maximale Stromabweichung mindestens einen Beitrag berücksichtigt, der aus der Liste ausgewählt ist, die aus einem ersten Beitrag von einem Stromsensor, der die Stromwerte bereitstellt, einem zweiten Beitrag von der Selbstentladung des mindestens einen elektrochemischen Elements (12) und einem dritten Beitrag von Fehlern bei der Schätzung der Kapazität des mindestens einen elektrochemischen Elements (12) besteht.

4. Verfahren zur Schätzung nach Anspruch 3, wobei das Verfahren ferner einen Schwellenwertbestimmungsschritt umfasst, wobei der Schwellenwert gleich dem Verhältnis zwischen dem Wert der Ladungsmenge, die seit dem vorherigen Zeitpunkt aufgrund der maximalen Stromabweichung wahrscheinlich angesammelt wird, und dem Wert der Kapazität des mindestens einen elektrochemischen Elements (12) ist.

5. Verfahren zur Schätzung nach einem der Ansprüche 1 bis 4, wobei der Spannungswert, der von dem zum gleichen Erfassungszeitpunkt erhaltenen Spannungswert des mindestens einen elektrochemischen Elements (12) abhängt, der zum gleichen Erfassungszeitpunkt erhaltene Spannungswert des mindestens einen elektrochemischen Elements (12) ist.

6. Verfahren zur Schätzung nach einem der Ansprüche 1 bis 4, wobei das Verfahren ferner einen Schritt des Schätzens des stationären Spannungswerts zum Erfassungszeitpunkt umfasst, wobei der Spannungswert, der von dem zum gleichen Erfassungszeitpunkt erhaltenen Spannungswert des mindestens einen elektrochemischen Elements (12) abhängt, der geschätzte stationäre Spannungswert ist.

7. Verfahren zur Schätzung nach Anspruch 6, wobei der Schätzungsschritt durch Anwenden eines Modells (M4) zur Schätzung der stationären Spannung auf den Spannungswert des mindestens einen elektrochemischen Elements (12) zum Erfassungszeitpunkt, den Stromwert des mindestens einen elektrochemischen Elements (12) zum Erfassungszeitpunkt und die seit dem vorherigen Zeitpunkt verstrichene Zeit implementiert wird.

8. Verfahren zur Schätzung nach einem der Ansprüche 1 bis 7, wobei das neuronale Netzwerk (M2) ein Mehrschicht-Perzeptron ist.

9. Verfahren zur Schätzung nach einem der Ansprüche 1 bis 8, wobei das neuronale Netzwerk (M2) eine Anzahl von Neuronen kleiner oder gleich 100 umfasst.

10. Verfahren zur Schätzung nach einem der Ansprüche 1 bis 9, wobei der anfängliche geschätzte Wert des Ladezustands (SOC) aus den vordefinierten Werten und dem zweiten berechneten Wert ausgewählt wird.

11. Verfahren zur Schätzung nach einem der Ansprüche 1 bis 10, wobei das mindestens eine elektrochemische Element (12) eine Ladezustand (SOC) - Leerlaufspannung (OCV)-Kennlinie mit einem flachen Abschnitt aufweist, wobei ein flacher Abschnitt ein Abschnitt ist, in dem die Änderung der Leerlaufspannung (OCV) bei einer Änderung des Ladezustands (SOC) um mindestens 10 % kleiner als 30 mV ist.

12. Verfahren zur Schätzung nach einem der Ansprüche 1 bis 11, wobei das mindestens eine elektrochemische Element (12) ein aktives Kathodenmaterial umfasst, das aus den folgenden Gruppen oder deren Gemischen ausgewählt ist:
i) eine Verbindung der Formel LiₓFe_{1-y}M_{y}PO₄, wobei M aus der Gruppe ausgewählt ist, die aus B, Mg, Al, Si, Ca, Ti, V, Cr, Mn, Co, Ni, Cu, Zn, Y, Zr, Nb und Mo besteht; und 0.8≤x≤1.2; 0≤y≤0.6,
ii) eine Verbindung der Formel LiₓMn_{1-y-z}M'_{y}M"_{z}PO₄, wobei M' und M" voneinander verschieden sind und aus der Gruppe ausgewählt sind, die aus B, Mg, Al, Si, Ca, Ti, V, Cr, Fe, Co, Ni, Cu, Zn, Y, Zr, Nb und Mo besteht, mit 0.8≤x≤1.2; 0≤y≤0.6; 0.0≤z≤0.2,
iii) eine Verbindung der Formel LiₓMn_{2-y-z}Ni_{y}M_{z}O_{4-d-c}F_{c}, wobei M ein oder mehrere Elemente darstellt, die aus der Gruppe ausgewählt sind, die aus B, Mg, Al, Si, Ca, Ti, V, Cr, Fe, Co, Cu, Zn, Y, Zr, Nb, Ru, W und Mo besteht; und 1≤x≤1.4; 0<y≤0.6; 0≤z≤0.2; 0≤d≤1; 0≤c≤1,
iv) eine Verbindung der Formel LiₓMn_{2-y-z}M'_{y}M"_{z}O₄, wobei M' und M" aus der Gruppe ausgewählt sind, die aus B, Mg, Al, Si, Ca, Ti, V, Cr, Fe, Co, Ni, Cu, Zn, Y, Zr, Nb und Mo besteht; wobei M' und M" voneinander verschieden sind, und 1≤x≤1.4; 0≤y≤0.6; 0≤z≤0.2, und
v) eine Verbindung der Formel LiVPO₄F.

13. Ein Computer, der in der Lage ist, den Ladezustand (SOC) von mindestens einem elektrochemischen Element (12) einer Batterie (10) zu schätzen,
wobei der Computer (22) ein Modell (M2) zur Schätzung des Ladezustands speichert, das aus einem Spannungswert, einem Stromwert, einem Temperaturwert und einem Kapazitätswert des mindestens einen elektrochemischen Elements (12) den Wert des Ladezustands (SOC) des mindestens einen elektrochemischen Elements (12) schätzt, wobei das Modell (M2) zur Schätzung des Ladezustands ein erlerntes neuronales Netzwerk ist,
wobei der Computer (22) für mehrere Zeitpunkte in der Lage ist:
- die Werte für die Spannung, den Strom, die Temperatur und die Kapazität des mindestens einen elektrochemischen Elements (12) zu erhalten,
- den Wert des Ladezustands (SOC) des mindestens einen elektrochemischen Elements (12) gemäß einer ersten Technik und einer zweiten Technik zu berechnen,
wobei die erste Technik die folgenden Vorgänge umfasst:
- Erhalten eines geschätzten Werts des Ladezustands (SOC), der zu einem vorherigen Zeitpunkt erhalten wurde,
- Berechnung des Werts der seit dem vorherigen Zeitpunkt angesammelten Ladungsmenge unter Verwendung der erhaltenen Stromwerte,
- Ableitung eines ersten berechneten Werts des Ladezustands (SOC) durch Berechnung der Summe des geschätzten Werts des Ladezustands (SOC), der zum vorherigen Zeitpunkt erhalten wurde, und des Verhältnisses des Werts der seit dem vorherigen Zeitpunkt angesammelten Ladungsmenge und des Kapazitätswerts des mindestens einen elektrochemischen Elements (12),
wobei die zweite Technik die folgenden Vorgänge umfasst:
- Anwenden des Modells (M2) zur Schätzung des Ladezustands auf die für den Strom, die Temperatur und die Kapazität des mindestens einen elektrochemischen Elements (12) zum selben Erfassungszeitpunkt erhaltenen Werte und auf einen Spannungswert, der von dem für die Spannung des mindestens einen elektrochemischen Elements (12) zum selben Erfassungszeitpunkt erhaltenen Wert abhängt, um einen zweiten berechneten Wert für den Ladezustand (SOC) zu erhalten,
wobei der Computer (22) **dadurch gekennzeichnet ist, dass** er ferner für mehrere Zeitpunkte in der Lage ist:
- die Differenz im Absolutwert zwischen dem zweiten berechneten Wert und dem ersten berechneten Wert und einen Schwellenwert zu vergleichen, und
- wenn die Differenz im Absolutwert zwischen dem zweiten berechneten Wert und dem ersten berechneten Wert kleiner oder gleich dem Schwellenwert ist, den geschätzten Wert des Ladezustands (SOC) als den zweiten berechneten Wert des Ladezustands (SOC) zu bestimmen,
oder
- wenn die Differenz im Absolutwert zwischen dem zweiten berechneten Wert und dem ersten berechneten Wert strikt größer als der Schwellenwert ist, den geschätzten Wert des Ladezustands (SOC) als die Summe des ersten berechneten Werts des Ladezustands (SOC) und eines zum Schwellenwert proportionalen Korrekturfaktors zu bestimmen.

14. Ein Managementsystem (14) für mindestens ein elektrochemisches Element (12) einer Batterie (10), wobei das mindestens eine elektrochemische Element (12) Anschlüsse aufweist, wobei das Managementsystem (14) umfasst:
- einen Spannungssensor (16), der in der Lage ist, die Spannung an den Anschlüssen des genannten mindestens einen elektrochemischen Elements (12) zu messen,
- einen Stromsensor (18), der in der Lage ist, den von dem genannten mindestens einen elektrochemischen Element (12) gelieferten Strom zu messen,
- einen Temperatursensor (20), der in der Lage ist, die Temperatur des genannten mindestens einen elektrochemischen Elements (12) zu messen, und
- einen Computer (22) nach Anspruch 13.

15. Eine Batterie, umfassend:
- mindestens ein elektrochemisches Element (12), und
- ein Managementsystem (14) nach Anspruch 14.

## Claims

1. A method for estimating the state of charge (SOC) of at least one electrochemical element (12) of a battery (10),
the method being implemented by a computer (22), the computer (22) storing a state of charge estimation model (M2) estimating from a voltage value, a current value, a temperature value and a capacity value of the at least one electrochemical element (12) the value of the state of charge (SOC) of the at least one electrochemical element (12), the state of charge estimation model (M2) being a learned neural network,
the method comprising, for a plurality of instants, the steps of:
- obtention of values for the voltage, current, temperature and capacity of the at least one electrochemical element (12),
- calculation of the value of the state of charge (SOC) of the at least one electrochemical element (12) using a first technique and a second technique,
the first technique including the following operations:
- obtention of an estimated value of the state of charge (SOC) obtained at a previous instant,
- calculation of the value of the quantity of charge accumulated since the previous instant, using the obtained current values,
- deduction of a first calculated value of the state of charge (SOC) by calculating the sum of the estimated value of the state of charge (SOC) obtained at the previous instant and the ratio of the value of the quantity of charge accumulated since the previous instant and the value of the capacity of the at least one electrochemical element (12),
the second technique including the following operations:
- application of the state of charge estimation model (M2) to the values obtained for the current, the temperature and the capacity of the at least one electrochemical element (12) at the same instant, and to a voltage value depending on the value obtained for the voltage of the at least one electrochemical element (12) at the same instant, to obtain a second calculated state of charge (SOC) value,
the method being **characterized in that** it further comprises, for several instants, the steps of:
- comparison of the difference in absolute value between the second calculated value and the first calculated value with the absolute value of a threshold, and
- when the difference in absolute value between the second calculated value and the first calculated value is less than or equal to the threshold, determination of the estimated value of the state of charge (SOC) as being the second calculated value of the state of charge (SOC),
or
- when the difference in absolute value between the second calculated value and the first calculated value is strictly greater than the threshold, determination of the estimated value of the state of charge (SOC), as being the sum of the first calculated value of the state of charge (SOC) and a correction factor proportional to the threshold.

2. The method for estimating according to claim 1, wherein the correction factor is equal to the product of a coefficient, a direction value and the threshold, the direction value being equal to the ratio between the difference of the second calculated value and the first calculated value and the absolute value of the difference of the second calculated value and the first calculated value, the coefficient advantageously being between 1 and 2.

3. The method for estimating according to claim 1 or 2, wherein the threshold depends on the maximum current bias, the maximum current bias taking into account at least one contribution chosen from the list constituted of a first contribution coming from a current sensor providing the current values, a second contribution coming from the self-discharge of the at least one electrochemical element (12) and a third contribution coming from errors on the estimation of the capacity of the at least one electrochemical element (12).

4. The method for estimating according to claim 3, wherein the method further includes a threshold determination step, the threshold being equal to the ratio between the value of the quantity of charge likely to be accumulated since the previous instant due to the maximum current bias and the value of the capacity of the at least one electrochemical element (12).

5. The method for estimating according to any one of claims 1 to 4, wherein the voltage value depending on the obtained voltage value of the at least one electrochemical element (12) at the same instant of obtention is the obtained voltage value of the at least one electrochemical element (12) at the same instant of obtention.

6. The method for estimating according to any one of claims 1 to 4, wherein the method further includes a step of estimating the steady state voltage value at the instant of obtention, the voltage value depending on the obtained voltage value of the at least one electrochemical element (12) at the same instant of obtention being the estimated steady state voltage value.

7. The method for estimating according to claim 6, wherein the estimation step is implemented by applying a steady state voltage estimation model (M4) to the voltage value of the at least one electrochemical element (12) at the instant of obtention, the current value of the at least one electrochemical element (12) at the instant of obtention and the time elapsed since the previous instant.

8. The method for estimating according to any one of claims 1 to 7, wherein the neural network (M2) is a multilayer perceptron.

9. The method for estimating according to any one of claims 1 to 8, wherein the neural network (M2) includes a number of neurons less than or equal to 100.

10. The method for estimating according to any one of claims 1 to 9, wherein the initial estimated value of the state of charge (SOC) is chosen from among the predefined values and the second calculated value.

11. The method for estimating according to any one of claims 1 to 10, wherein the at least one electrochemical element (12) presents a state of charge (SOC) - open circuit voltage (OCV) characteristic with a flat portion, a flat portion being a portion wherein the open circuit voltage (OCV) variation is less than 30 mV for a variation of at least 10% in the state of charge (SOC).

12. The method for estimating according to any one of claims 1 to 11, wherein the at least one electrochemical element (12) comprises a cathode active material chosen from among the following groups or mixtures thereof:
i) a compound of the formula LiₓFe_{1-y}MyPO₄ where M is chosen from the group consisting of B, Mg, Al, Si, Ca, Ti, V, Cr, Mn, Co, Ni, Cu, Zn, Y, Zr, Nb and Mo; and 0.8≤x≤1.2; 0≤y≤0.6,
ii) a compound of formula LiₓMn_{1-y-z}M'_{y}M"_{z}PO₄, where M' and M" are different from each other and are chosen from the group consisting of B, Mg, Al, Si, Ca, Ti, V, Cr, Fe, Co, Ni, Cu, Zn, Y, Zr, Nb and Mo, with 0.8≤x≤1.2; 0≤y≤0.6; 0.0≤z≤0.2,
iii) a compound of formula LiₓMn_{2-y-}zNi_{y}M_{z}O_{4-d-c}F_{c} where M represents one or more elements chosen from the group consisting of B, Mg, Al, Si, Ca, Ti, V, Cr, Fe, Co, Cu, Zn, Y, Zr, Nb, Ru, W and Mo; and 1≤x≤1.4; 0<y≤0.6; 0≤z≤0.2; 0≤d≤1; 0≤c≤1,
iv) a compound of the formula LiₓMn_{2-y-z}M'_{y}M"_{z}O₄, where M' and M" are chosen from the group consisting of B, Mg, Al, Si, Ca, Ti, V, Cr, Fe, Co, Ni, Cu, Zn, Y, Zr, Nb and Mo; M' and M" being different from each other, and 1≤x≤1.4; 0≤y≤0.6; 0≤z≤0.2, and
v) a compound of the formula LiVPO₄F.

13. A computer able to estimate the state of charge (SOC) of at least one electrochemical element (12) of a battery (10),
the computer (22) storing a state of charge estimation model (M2) estimating from a voltage value, a current value, a temperature value and a capacity value of the at least one electrochemical element (12) the value of the state of charge (SOC) of the at least one electrochemical element (12), the state of charge estimation model (M2) being a learned neural network,
the computer (22) being, for several instants, able to:
- obtain the values for the voltage, the current, the temperature and the capacity of the at least one electrochemical element (12),
- calculate the value of the state of charge (SOC) of the at least one electrochemical element (12) according to a first technique and a second technique,
the first technique including the following operations:
- obtain of an estimated value of the state of charge (SOC) obtained at a previous instant,
- calculation of the value of the quantity of charge accumulated since the previous instant, using the current values obtained,
- deduction of a first calculated value of the state of charge (SOC) by calculation of the sum of the estimated value of the state of charge (SOC) obtained at the previous instant and the ratio of the value of the quantity of charge accumulated since the previous instant and the value of the capacity of the at least one electrochemical element (12),
the second technique including the following operations:
- application of the state of charge estimation model (M2) to the values obtained for the current, temperature and capacity of the at least one electrochemical element (12) at the same instant of obtention, and to a voltage value dependent on the value obtained for the voltage of the at least one electrochemical element (12) at the same instant of obtention, to obtain a second calculated value for the state of charge (SOC), and
The computer (22) being **characterized in that** it further, for several instants, is able to:
- compare the difference in absolute value between the second calculated value and the first calculated value and a threshold, and
- when the difference in absolute value between the second calculated value and the first calculated value is less than or equal to the threshold, determine the estimated value of the state of charge (SOC) as being the second calculated value of the state of charge (SOC),
or
- when the difference in absolute value between the second calculated value and the first calculated value is strictly greater than the threshold, determine the estimated value of the state of charge (SOC), as being the sum of the first calculated value of the state of charge (SOC) and a correction factor proportional to the threshold.

14. A management system (14) for at least one electrochemical element (12) of a battery (10), the at least one electrochemical element (12) presenting terminals, the management system (14) comprising:
- a voltage sensor (16) able to measure the voltage at the terminals of said at least one electrochemical element (12),
- a current sensor (18) able to measure the current delivered by said at least one electrochemical element (12),
- a temperature sensor (20) able to measure the temperature of said at least one electrochemical element (12), and
- a computer (22) according to claim 13.

15. A battery comprising:
- at least one electrochemical element (12), and
- a management system (14) according to claim 14.
